# EUROPEAN PATENT APPLICATION

(11) **EP 4 658 047 A1**
(43) Date of publication of application: **03.12.2025**
(21) Application number: 25179100.0
(22) Date of filing: 27.05.2025
(51) Int. Cl.: H10K 59/131, H10K 59/126, H10K 59/65

(54) **DISPLAY DEVICE AND ELECTRONIC DEVICE INCLUDING THE SAME**

(30) Priority: 31.05.2024 KR 20240071526
(71) Applicant: Samsung Display Co., Ltd., Yongin-si, Gyeonggi-do 17113 (KR)
(72) Inventor: Shin, Dong Hee, 17113 Yongin-si, Gyeonggi-do (KR); Son, Sun Kwun, 17113 Yongin-si, Gyeonggi-do (KR)
(74) Representative: Gulde & Partner

(57) **Abstract**

A display device according to one or more embodiments may include a substrate, first sub-pixels, second sub-pixels, and third sub-pixels respectively arranged in a first pixel row and a second pixel row extending in a first direction, light-sensing pixels between respective ones of the second sub-pixels and the third sub-pixels in the first pixel row and the second pixel row, and including a sensor circuit, a first data line electrically connected to the second sub-pixels, a second data line electrically connected to the third sub-pixels, and a readout line electrically connected to the light-sensing pixels, between the first data line and the second data line in plan view, adjacent to one of the first data line or the second data line in the first pixel row, and adjacent to a remaining one of the first data line or the second data line in the second pixel row.

## Description

### BACKGROUND

### 1. Field

The disclosure relates to a display device, and an electronic apparatus (e.g., electronic device) including the same.

### 2. Description of the Related Art

Recently, interest in information display has been increasing. Accordingly, research and development on display devices is being continuously conducted.

### SUMMARY

The disclosure may provide a display device with improved reliability and an electronic device including the same.

A display device according to one or more embodiments may include a substrate, first sub-pixels, second sub-pixels, and third sub-pixels respectively arranged in a first pixel row and a second pixel row extending in a first direction, light-sensing pixels between respective ones of the second sub-pixels and the third sub-pixels in the first pixel row and the second pixel row, and including a sensor circuit, a first data line electrically connected to the second sub-pixels, a second data line electrically connected to the third sub-pixels, and a readout line electrically connected to the light-sensing pixels, between the first data line and the second data line in plan view, adjacent to one of the first data line or the second data line in the first pixel row, and adjacent to a remaining one of the first data line or the second data line in the second pixel row.

The readout line may be closer to the second data line than the first data line in the first pixel row, and closer to the first data line than the second data line in the second pixel row.

The first data line, the readout line, and the second data line may be at a same layer.

The display device may further include a reset line electrically connected to the light-sensing pixels, and configured to receive a reset voltage, horizontal bridge line extending in the first direction in the first pixel row and the second pixel row, a first vertical bridge line at the second sub-pixels in the first pixel row and the second pixel row, and a second vertical bridge line at the second sub-pixels in the first pixel row and the second pixel row.

The reset line may include a first line at a same layer as the horizontal bridge line, and extending in the first direction, and a second line between the first line and the readout line, electrically connected to the first line, and including a first sub-line extending in the first direction, and a second sub-line extending in a second direction crossing the first direction, and overlapping the readout line.

The first sub-line may be in an overlap area where the horizontal bridge line and the readout line overlap.

The first sub-line may be configured to shield a coupling capacitance between the horizontal bridge line and the readout line in the overlap area.

The second line may further include a third sub-line in the first pixel row, extending from the first sub-line in the second direction, spaced from the second sub-line, and not overlapping the readout line in plan view.

The second sub-line may be closer to the second data line than the first data line in the first pixel row, and is closer to the first data line than the second data line in the second pixel row.

The readout line may be closer to the first data line than the second data line in the first pixel row, and closer to the second data line than the first data line in the second pixel row.

The second line may further include a third sub-line in the second pixel row, extending from the first sub-line in the second direction, spaced from the second sub-line, and not overlapping the readout line.

The second sub-line may be closer to the first data line than the second data line in the first pixel row, and closer to the second data line than the first data line in the second pixel row.

The first sub-pixels, the second sub-pixels, and the third sub-pixels may include a light-emitting element configured to emit light, wherein the light-sensing pixels include a light-receiving element configured to output a sensing signal corresponding to the light.

The display device may further include first, second, third, fourth, fifth, sixth, seventh, eighth, and ninth insulating layers sequentially arranged above the substrate, a first conductive layer between the second insulating layer and the third insulating layer, a second conductive layer between the third insulating layer and the fourth insulating layer, a third conductive layer between the fifth insulating layer and the sixth insulating layer, a fourth conductive layer between the sixth insulating layer and the seventh insulating layer, and including the horizontal bridge line, a fifth conductive layer between the seventh insulating layer and the eighth insulating layer, and including the first sub-line and the second sub-line, and a sixth conductive layer between the eighth insulating layer and the ninth insulating layer, and including the first vertical bridge line and the second vertical bridge line, the first and second data lines, and the readout line.

The readout line in the first pixel row and the readout line in the second pixel row may be in different respective columns.

A display device according to one or more embodiments may include a substrate, first sub-pixels, second sub-pixels, and third sub-pixels respectively in a first pixel row and a second pixel row extending in a first direction, light-sensing pixels between respective ones of the second sub-pixels and the third sub-pixels in the first pixel row and in the second pixel row, and including a sensor circuit, a first data line electrically connected to the second sub-pixels, and extending in a second direction crossing the first direction, a second data line electrically connected to the third sub-pixels, and extending in the second direction, a readout line electrically connected to the light-sensing pixels, and extending in the second direction, and a reset line electrically connected to the light-sensing pixels, configured to receive a reset voltage, and including a first line extending in the first direction, and a second line above the first line with an insulating layer therebetween, electrically connected to the first line, and including a first sub-line extending in the first direction and overlapping the first line, and a second sub-line overlapping the readout line and extending from the first sub-line along the second direction in different respective columns in the first pixel row and in the second pixel row.

The readout line may be in different respective columns in the first pixel row and in the second pixel row.

The readout line may be between the first data line and the second data line in plan view, wherein the readout line is adjacent to one of the first data line or the second data line in the first pixel row, and is adjacent to a remaining one of the first data line or the second data line in the second pixel row.

An electronic device according to one or more embodiments may include a processor configured to provide input image data, and a display device configured to display an image based on the input image data, and including a substrate, first sub-pixels, second sub-pixels, and third sub-pixels respectively in a first pixel row and a second pixel row extending in a first direction, light-sensing pixels between respective ones of the second sub-pixels and the third sub-pixels in the first pixel row and in the second pixel row, and including a sensor circuit, a first data line electrically connected to the second sub-pixels, a second data line electrically connected to the third sub-pixels, and a readout line electrically connected to the light-sensing pixels, between the first data line and the second data line in plan view, adjacent to one of the first data line or the second data line in the first pixel row, and adjacent to a remaining one of the first data line or the second data line in the second pixel row.

The readout line may be closer to the second data line than the first data line in the first pixel row, and is closer to the first data line than the second data line in the second pixel row.

### BRIEF DESCRIPTION OF THE DRAWINGS

FIG. 1 is a schematic block diagram illustrating a display device in accordance with one or more embodiments.
FIG. 2 is a schematic block diagram illustrating one or more embodiments of the display device of FIG. 1.
FIG. 3 is a schematic plan view illustrating a display device in accordance with one or more embodiments.
FIG. 4 is a schematic enlarged view illustrating a region EA1 of FIG. 3.
FIG. 5 is a schematic diagram illustrating an example of the arrangement of pixel circuits and sensor circuits in a display area of a display panel included in the display device of FIG. 2.
FIG. 6 is a schematic diagram illustrating an example of the display area of the display panel included in the display device of FIG. 2.
FIG. 7 is a schematic circuit diagram illustrating an example of a sub-pixel and a light-sensing pixel included in the display area of FIG. 1.
FIG. 8 is a schematic cross-sectional view illustrating one region of a display device in accordance with one or more embodiments.
FIG. 9 is a schematic cross-sectional view illustrating a reflection path of light in the display device of FIG. 8.
FIG. 10 is a schematic plan view illustrating sub-pixels and a first light-sensing pixel in accordance with one or more embodiments.
FIG. 11 is a schematic plan view illustrating only first, second, fifth, sixth, seventh, eighth, ninth, and eleventh transistors and components included in a first conductive layer in FIG. 10.
FIG. 12 is a schematic plan view illustrating only components included in a second conductive layer in FIG. 10.
FIG. 13 is a schematic plan view illustrating only third, fourth, and tenth transistors and components included in a third conductive layer in FIG. 10.
FIG. 14 is a schematic plan view illustrating only components included in a fourth conductive layer in FIG. 10.
FIG. 15 is a schematic plan view illustrating only components included in a fifth conductive layer in FIG. 10.
FIG. 16 is a schematic plan view illustrating only components included in a sixth conductive layer in FIG. 10.
FIG. 17 is a schematic plan view illustrating only components included in a fourth conductive layer, a fifth conductive layer, and a sixth conductive layer in FIG. 10.
FIG. 18 is a schematic enlarged view illustrating a region EA2 of FIG. 17.
FIG. 19 is a schematic cross-sectional view taken along the line I-I' of FIG. 18.
FIG. 20 is a schematic plan view illustrating sub-pixels and light-sensing pixels arranged in first and second pixel rows located in one region of a display area of a display device in accordance with one or more embodiments.
FIG. 21 is a schematic plan view illustrating only components included in a fifth conductive layer in FIG. 20.
FIG. 22 is a schematic plan view illustrating only components included in a sixth conductive layer in FIG. 20.
FIG. 23 is a schematic diagram illustrating a connection relationship of some lines in one region of a display area of a display device in accordance with one or more embodiments.
FIG. 24 is a schematic plan view illustrating sub-pixels and light-sensing pixels arranged in first and second pixel rows located in one region of a display area of a display device in accordance with one or more embodiments.
FIG. 25 is a schematic plan view illustrating only components included in a fifth conductive layer in FIG. 24.
FIG. 26 is a schematic plan view illustrating only components included in a sixth conductive layer in FIG. 24.
FIG. 27 is a schematic diagram illustrating a connection relationship of some lines in one region of a display area of a display device in accordance with one or more embodiments.
FIG. 28 is a schematic block diagram illustrating an electronic device in accordance with one or more embodiments.
FIG. 29 is a schematic diagram illustrating an example in which the electronic device of FIG. 28 is implemented as a smartphone.
FIG. 30 is a schematic diagram illustrating an example in which the electronic device of FIG. 28 is implemented as a tablet PC.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, the disclosure is not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

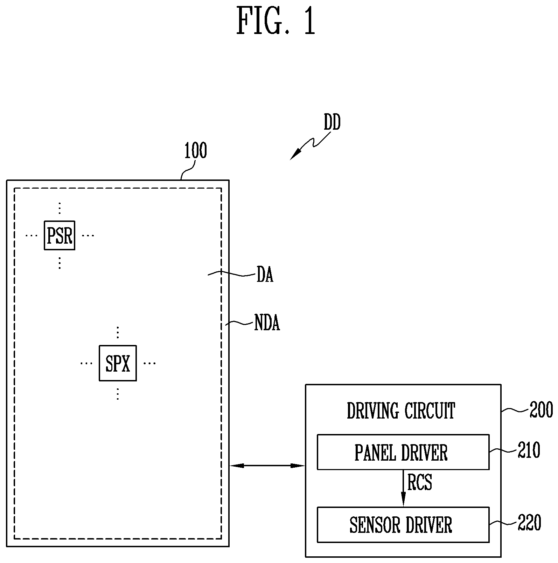

FIG. 1 is a schematic block diagram illustrating a display device DD in accordance with one or more embodiments.

Referring to FIG. 1, the display device DD in accordance with one or more embodiments may include a display panel 100 and a driving circuit 200. In one or more embodiments, the driving circuit 200 may include a panel driver 210 and a sensor driver 220.

The display device DD may be implemented as a self-luminous display device including a plurality of self-luminous elements. For example, the display device DD may be an organic light-emitting display device including an organic light-emitting element. However, the present disclosure is not limited thereto, and the display device DD may be implemented as a display device including an inorganic light-emitting element, a display device including light-emitting elements including a composite of an inorganic material and an organic material, or a display device that displays an image using quantum dots.

The display device DD may be a flat-panel display device, a flexible display device, a curved display device, a foldable display device, a bendable display device, and a rollable display device. The display device DD may be applied to a transparent display device, a head-mounted display device, a wearable display device, etc.

The display panel 100 may include a display area DA and a non-display area NDA. The display area DA may be an area where sub-pixels SPX (or pixels) are provided. The sub-pixel SPX may include at least one light-emitting element. For example, the light-emitting element may include an emission layer (e.g., an organic emission layer). A portion in which light is emitted by the light-emitting element may be defined as the emission area. The display device DD may display an image in the display area DA by driving the sub-pixel SPX in response to image data.

The non-display area NDA may be an area provided around the display area DA. In one or more embodiments, the non-display area NDA may comprehensively refer to the remaining area on the display panel 100, excluding the display area DA. For example, the non-display area NDA may include a wiring area, a pad area, and various dummy areas.

The display area DA may include a light-sensing pixel PSR. The light-sensing pixel PSR may be referred to as a light sensor. The light-sensing pixel PSR may include a light-receiving element including a light-receiving layer. In the display area DA, the light-receiving layer of the light-receiving element may be spaced from the emission layer of the light-emitting element.

A plurality of light-sensing pixels PSR may be distributed over the entire display area DA and spaced from each other. However, the present disclosure is not limited thereto, and only one region of the display area DA may be set as a certain sensing area, and the light-sensing pixels PSR may be provided in the corresponding sensing area. The light-sensing pixels PSR may be provided in at least a portion of the non-display area NDA.

The light-sensing pixel PSR may sense that light emitted from a light source (e.g., the light-emitting element of the sub-pixel SPX) is reflected by an external object (e.g., a user's finger, etc.). For example, a user's fingerprint may be sensed through the light-sensing pixel PSR. Hereinafter, a case where the light-sensing pixel PSR is used for fingerprint sensing is described for example, but in various embodiments, the light-sensing pixel PSR may sense a variety of biometric information, such as an iris and/or veins.

The driving circuit 200 may include the panel driver 210 and the sensor driver 220. The panel driver 210 and the sensor driver 220 may be implemented as independent integrated circuits. In accordance with one or more embodiments, the driving circuit 200 may be implemented as a single integrated circuit. In this case, at least a portion of the sensor driver 220 may be included in the panel driver 210, or may operate in conjunction with the panel driver 210.

The panel driver 210 may scan the sub-pixel SPX of the display area DA and supply, to the sub-pixel SPX, a data signal corresponding to image data (or image). The display panel 100 may display an image corresponding to the data signal.

The panel driver 210 may supply a driving signal for light sensing (e.g., fingerprint sensing) to the sub-pixel SPX. The driving signal may be provided to cause the sub-pixel SPX to emit light, and to operate as a light source for the light-sensing pixel PSR. The panel driver 210 may also supply the driving signal for light sensing and/or other driving signals to the light-sensing pixel PSR. However, the present disclosure is not limited thereto, and the driving signals for light sensing may be supplied to the light-sensing pixel PSR by the sensor driver 220.

The sensor driver 220 may detect biometric information, such as a user's fingerprint, based on a sensing signal received from the light-sensing pixel PSR. In accordance with one or more embodiments, the sensor driver 220 may supply the driving signals to the light-sensing pixel PSR and/or the sub-pixel SPX.

The panel driver 210 may provide a readout control signal RCS to the sensor driver 220, and the sensor driver 220 may read out (or sample) a sensing signal in conjunction with the panel driver 210, based on the readout control signal RCS. For example, the sensor driver 220 may read out or sample the sensing signal in units of at least one pixel row (or horizontal line) in response to the readout control signal RCS.

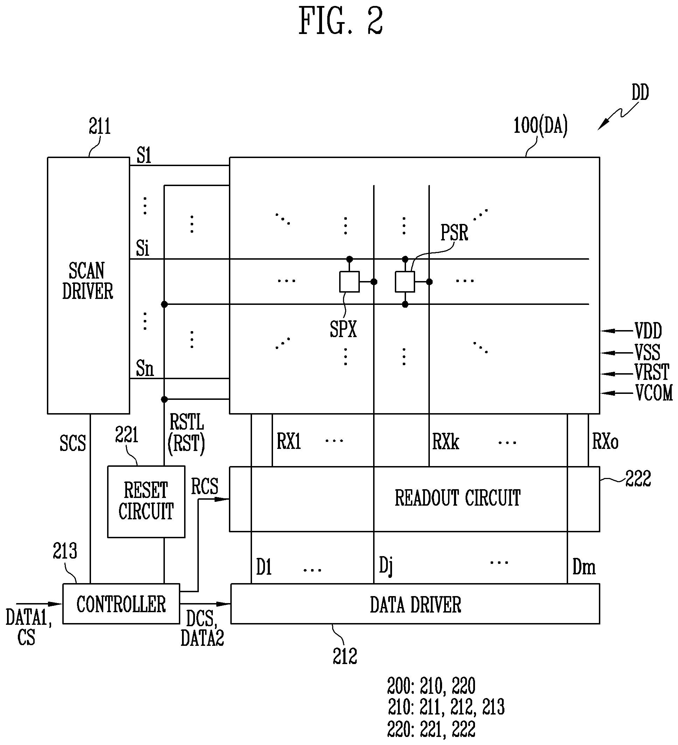

FIG. 2 is a schematic block diagram illustrating one or more embodiments of the display device DD of FIG. 1.

Referring to FIGS. 1 and 2, the display device DD may include the display panel 100 and the driving circuit 200.

The display panel 100 may include signal lines, sub-pixels SPX, and light-sensing pixels PSR. The signal lines may include scan lines S1 to Sn, data lines D1 to Dm, readout lines RX1 to RXo, and a reset line RSTL (or a reset control line). Here, n, m, and o may each be a natural number.

The sub-pixels SPX may be located in regions (e.g., pixel areas) partitioned by the scan lines S1 to Sn and the data lines D1 to Dm. The light-sensing pixels PSR may be located in regions defined by the scan lines S1 to Sn and the readout lines RX1 to RXo. The sub-pixels SPX and the light-sensing pixels PSR may be arranged in a two-dimensional array in the display area DA of the display panel 100, but the present disclosure is not limited thereto.

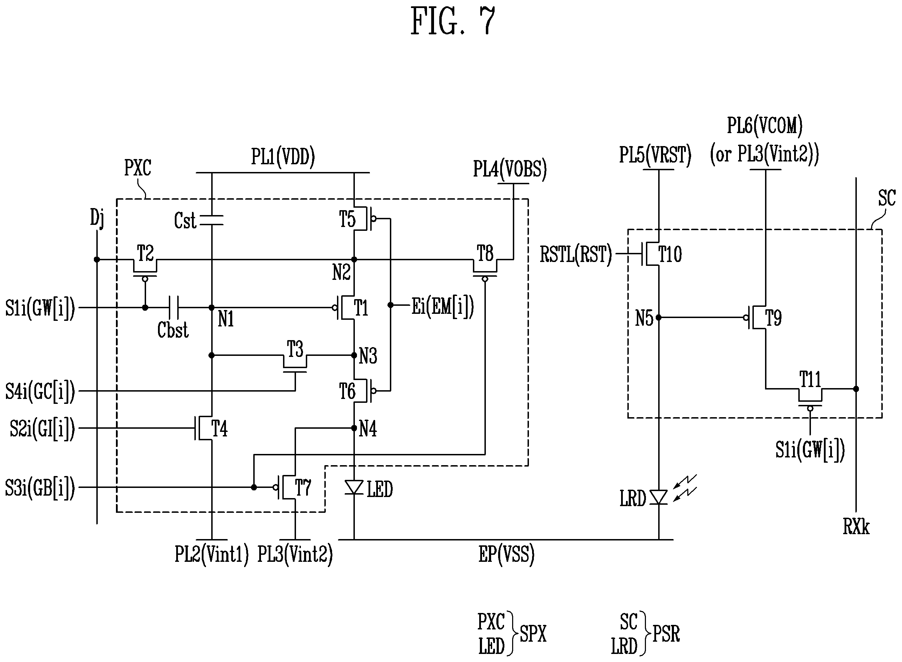

The sub-pixel SPX may be electrically connected to at least one of the scan lines S1 to Sn and at least one of the data lines D1 to Dm. The light-sensing pixel PSR may be electrically connected to one of the scan lines S1 to Sn, one of the readout lines RX1 to RXo, and the reset line RSTL. A connection configuration between the sub-pixels SPX, the light-sensing pixels PSR, and the signal lines is described below with reference to FIG. 7.

Power voltages VDD, VSS, VRST, and VCOM required to drive the sub-pixels SPX and the light-sensing pixels PSR may be provided to the display panel 100. The power voltages VDD, VSS, VRST, and VCOM may be supplied from a power supply. The power supply may be implemented as a power management integrated circuit (PMIC).

The driving circuit 200 may include a scan driver 211, a data driver 212, a controller 213, a reset circuit 221, and a readout circuit 222. For example, the scan driver 211, the data driver 212, and the controller 213 may be included in the panel driver 210, and the reset circuit 221 and the readout circuit 222 may be included in the sensor driver 220, but the present disclosure is not limited thereto. In accordance with one or more embodiments, the reset circuit 221 may be included in the panel driver 210.

The scan driver 211 may be electrically connected to the sub-pixels SPX and the light-sensing pixels PSR through the scan lines S1 to Sn. The scan driver 211 may generate scan signals based on the scan control signal SCS, and may supply the scan signals to the scan lines S1 to Sn. The scan control signal SCS may include a start signal, a clock signal, etc., and may be provided from the controller 213 to the scan driver 211. For example, the scan driver 211 may be implemented as a shift register that generates and outputs the scan lines S1 to Sn by sequentially shifting a start signal in the form of a pulse using clock signals. The scan driver 211 may selectively drive the sub-pixel SPX and the light-sensing pixel PSR while scanning the display panel 100.

The scan driver 211 may be formed together with the sub-pixel SPX of the display panel 100, but the present disclosure is not limited thereto. In accordance with one or more embodiments, the scan driver 211 may be implemented as an integrated circuit.

The sub-pixel SPX selectively driven by the scan driver 211 may emit light with a luminance corresponding to the data signal provided to the corresponding data line among the data lines D1 to Dm. The light-sensing pixel PSR selectively driven by the scan driver 211 may output an electrical signal (e.g., a sensing signal) corresponding to the sensed light to the corresponding readout line. For example, a sub-pixel SPX selectively driven through an i-th scan line Si may emit light with a luminance corresponding to a data signal supplied to a j-th data line Dj (where i and j are natural numbers). For example, the light-sensing pixel PSR selectively driven through the i-th scan line Si may output the electrical signal corresponding to the sensed light to a k-th readout line RXk (where k is a natural number).

The data driver 212 may generate a data signal (or a data voltage) based on image data DATA2 and a data control signal DCS provided from the controller 213, and may supply the data signal to the display panel 100 (or the sub-pixel SPX) through the data lines D1 to Dm. The data control signal DCS is a signal that controls the operation of the data driver 212, and may include a horizontal start signal, a data clock signal, etc. For example, the data driver 212 may include a shift register that generates a sampling signal by shifting the horizontal start signal in synchronization with the data clock signal, a latch that latches the image data DATA2 in response to the sampling signal, a digital-to-analog converter (or a decoder) that converts the latched image data (e.g., digital data) into an analog data signal, and a buffer (or an amplifier) that outputs the data signal to the corresponding data line (for example, the j-th data line Dj).

The controller 213 may receive input image data DATA1 and a control signal CS from an external device (e.g., a graphics processor, an application processor, a first processor, etc.), may generate a scan control signal SCS and a data control signal DCS based on the control signal CS, and may convert the input image data DATA1 to generate image data DATA2. The control signal CS may include a vertical synchronization signal, a horizontal synchronization signal, a reference clock signal, etc. The vertical synchronization signal may indicate the start of frame data (e.g., data corresponding to a frame period in which one frame image is displayed), and the horizontal synchronization signal may indicate the start of a data row (e.g., one of a plurality of data rows included in the frame data). The controller 213 may convert the input image data DATA1 into the image data DATA2 having a format that matches the pixel arrangement in the display panel 100.

The controller 213 may generate a reset control signal and a readout control signal RCS based on the control signal CS.

The reset circuit 221 may be commonly connected to all the light-sensing pixels PSR provided in the display panel 100 through one reset line RSTL. The reset circuit 221 may concurrently or substantially simultaneously supply the reset signal RST to all the light-sensing pixels PSR in response to the reset control signal. Because the reset signal RST is concurrently or substantially simultaneously supplied to all the light-sensing pixels PSR, the reset signal RST may be referred to as a global reset signal.

The readout circuit 222 may receive a sensing signal from the light-sensing pixel PSR through the readout lines RX1 to RXo, and may perform signal processing on the sensing signal.

For example, the readout circuit 222 may perform a correlated double sampling (CDS) operation to cancel noise from the sensing signal provided from the light-sensing pixel PSR. A timing of the CDS operation of the readout circuit 222 may be determined by the readout control signal RCS. The readout circuit 222 may convert an analog sensing signal into a digital signal (or a digital value). A configuration for the CDS and analog-to-digital conversion may be provided for each of the readout lines RX1 to RXo, and the readout circuit 222 may process the sensing signals provided from the readout lines RX1 to RXo in parallel.

The processed sensing signals, that is, the readout sensing signals, may be transmitted to an external device (e.g., an application processor) as a single piece of sensing data (or biometric information), and biometric authentication (e.g., fingerprint authentication, etc.) may be performed based on the sensing data. In accordance with one or more embodiments, the readout sensing signals may be supplied to the controller 213, and the controller 213 may perform biometric authentication.

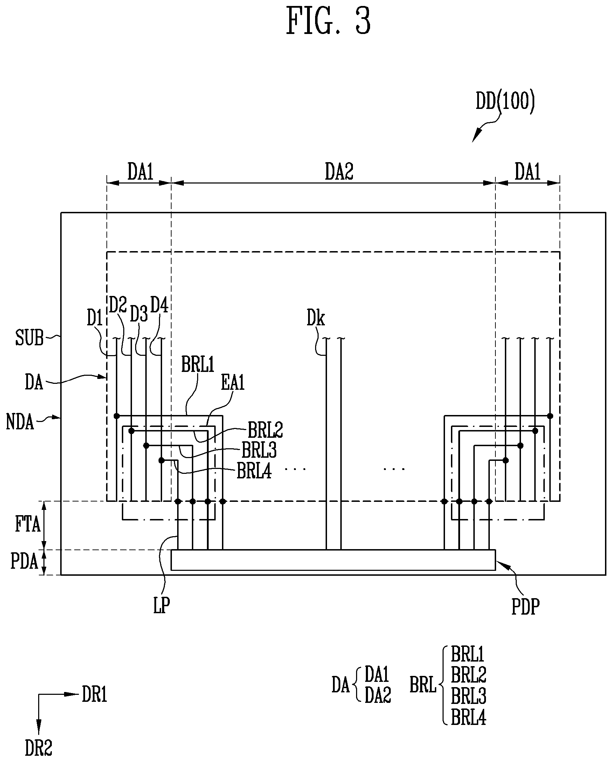

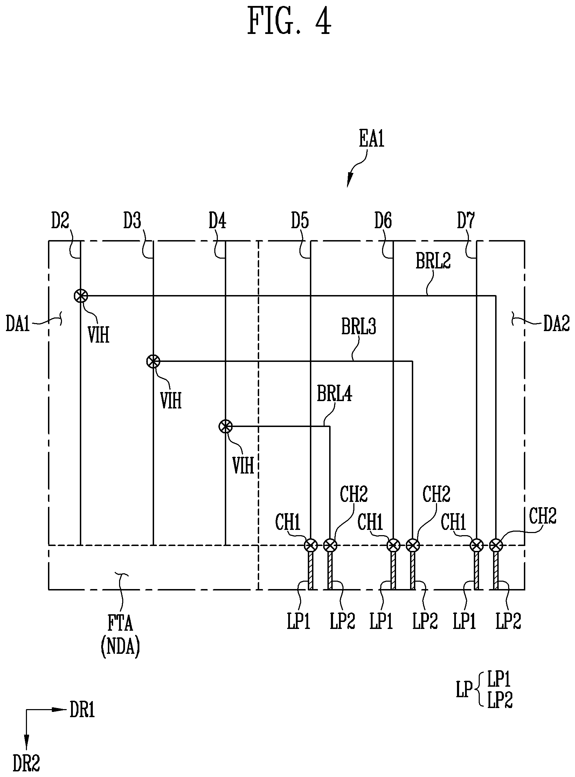

FIG. 3 is a schematic plan view illustrating a display device DD in accordance with one or more embodiments, and FIG. 4 is a schematic enlarged view illustrating a region EA1 of FIG. 3.

Referring to FIGS. 3 and 4, the display device DD (or the display panel 100) may include a substrate SUB on which a display area DA and a non-display area NDA are defined.

The display device DD may be provided in various shapes. For example, the display device DD may be provided in a rectangular plate shape with two pairs of sides parallel to each other, but the present disclosure is not limited thereto.

The substrate SUB may include a transparent insulating material to allow light to pass therethrough. The substrate SUB may be a rigid substrate or a flexible substrate.

The rigid substrate may be, for example, one of a glass substrate, a quartz substrate, a glass ceramic substrate, or a crystalline glass substrate.

The flexible substrate may be one of a plastic substrate or a film substrate including a polymer organic material. For example, the flexible substrate may include at least one of polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, cellulose triacetate, or cellulose acetate propionate.

The display area DA may include first areas DA1 and a second area DA2. For example, the display area DA may include the second area DA2 located in the central portion thereof, and the first areas DA1 respectively located on both sides with the second area DA2 therebetween. The first area(s) DA1 may be an area located in an outer direction of the display panel 100 rather than in the center direction with respect to the second area DA2, but the present disclosure is not limited thereto.

A sub-pixel (see "SPX" of FIG. 1) and a light-sensing pixel (see "PSR" of FIG. 1) may be located in each of the first area(s) DA1 and the second area DA2.

By selectively driving the sub-pixel SPX and the light-sensing pixel PSR in response to input image data, the display device DD may display an image in the first area(s) DA1 and the second area DA2, and may sense a user's fingerprint, etc.

The non-display area NDA may include a fan-out area FTA and a pad area PDA.

The pad area PDA may be located closest to the edge of the non-display area NDA.

The fan-out area FTA may be located adjacent to the display panel DA in the non-display area NDA. For example, the fan-out area FTA may be an area of the non-display area NDA located between the pad area PDA and the display area DA. In accordance with one or more embodiments, the non-display area NDA may include an anti-static circuit area including an anti-static circuit electrically connected to signal lines located in the display area DA to reduce or prevent the generation of static electricity.

A line portion LP may be located in the fan-out area FTA, and a pad portion PDP may be located in the pad area PDA.

The line unit LP may be electrically connected to the sub-pixel SPX and/or the light-sensing pixel PSR, and may transmit a certain signal applied from the driving circuit (see "200" of FIG. 1) to the signal lines. The line portion LP may include fan-out lines that electrically connect the driving circuit 200 to the sub-pixels SPX and/or the light-sensing pixel PSR in the fan-out area FTA.

In one or more embodiments, the line portion LP may be located in the central portion of the fan-out area FTA corresponding to the second area DA2 of the display area DA. The line portion LP may include a first line LP1 and a second line LP2. The first line LP1 may be electrically connected to data lines D5, D6, D7, ..., Dk located in the second area DA2 of the display area DA through first contact holes CH1. The second line LP2 may be electrically connected to data lines D1, D2, D3, and D4 located in the first area(s) DA1 of the display area DA through second contact holes CH2 and bridge lines BRL.

Signal lines to which various signals are applied may be located in the first area(s) DA1 and the second area DA2. For example, the data lines D1 to Dk to which data signals for adjusting the brightness of each sub-pixel SPX are applied may be located in the first area(s) DA1 and the second area DA2. To the data lines D1 to Dk, various signal lines, such as power lines and scan lines, may be located in the first area(s) DA1 and the second area DA2.

The data lines D1 to Dk may extend along the second direction DR2 in the display area DA. In FIGS. 3 and 4, the first to fourth data lines D1 to D4 may be located in the first area DA1 adjacent to one side (e.g., the left side) of the second area DA2. Four data lines may be located in the first area DA1 adjacent to the other side (e.g., the right side) of the second area DA2. For convenience of explanation, it is illustrated that four data lines are located in a first area DA1, but the present disclosure is not limited thereto.

Each of the fifth to k-th data lines D5 to Dk located in the second area DA2 may be electrically connected to the first line LP1. For example, in the second area DA2, each of the fifth data line D5, the sixth data line D6, and the seventh data line D7 may be electrically connected to the corresponding first line LP1 through the first contact hole CH1.

The first to fourth data lines D1 to D4 located in the first area(s) DA1 may be electrically connected to the bridge lines BRL. The bridge line BRL may be located to pass through the display area DA by bypassing a portion of the display area DA adjacent to the non-display area NDA.

The first data line D1 may be electrically connected to a first bridge line BRL1, the second data line D2 may be electrically connected to a second bridge line BRL2, the third data line D3 may be electrically connected to a third bridge line BRL3, and the fourth data line D4 may be electrically connected to a fourth bridge line BRL4.

Each of the first to fourth bridge lines BRL1 to BRL4 may extend from the second area DA2 to the first area(s) DA1. For example, each of the first to fourth bridge lines BRL1 to BRL4 may be routed from the central portion (or the inside) of the display area DA to the edge (or the outside) of the display area DA. The first to fourth bridge lines BRL1 to BRL4 may be respectively electrically connected to the first to fourth data lines D1 to D4 through via holes VIH, and may be electrically connected to the corresponding second lines LP2 through the second contact holes CH2.

In FIG. 4, the second bridge line BRL2 may have one end electrically connected to the second line LP2 through the second contact hole CH2, and the other end connected to the second data line D2 through the via hole VIH. The third bridge line BRL3 may have one end electrically connected to the second line LP2 through the second contact hole CH2, and the other end connected to the third data line D3 through the via hole VIH. The fourth bridge line BRL4 may have one end electrically connected to the second line LP2 through the second contact hole CH2, and the other end connected to the fourth data line D4 through the via hole VIH.

Each of the second to fourth bridge lines BRL2 to BRL4 may have one end electrically connected to the second line LP2 through the second contact hole CH2 between the second display area DA2 and the non-display area NDA, and the other end electrically connected to each of the second to fourth data lines D2 to D4 through the via hole VIH in the first area DA1. That is, each of the second to fourth bridge lines BRL2 to BRL4 may receive an input signal (e.g., a data signal) from the second line LP2, and may transmit the input signal to each of the second to fourth data lines D2 to D4. The second to fourth bridge lines BRL2 to BRL4 may be located on the same layer as the second line LP2, or may be located on a different layer from the second line LP2.

The fifth to seventh data lines D5 to D7 of FIG. 4 may be located on the same layer, or some of the data lines D5 to D7 may be located on different layers. For example, the fifth to seventh data lines D5 to D7 may be alternately located on different layers.

As described above, instead of directly connecting the data line to the line portion LP in a portion of the display area DA (e.g., the first area(s) DA1), the input signal of the line portion LP is allowed to be transmitted to the data line through the bridge line BRL that bypasses a portion of the display area DA, thereby effectively reducing the area of the non-display area NDA outside the display area DA.

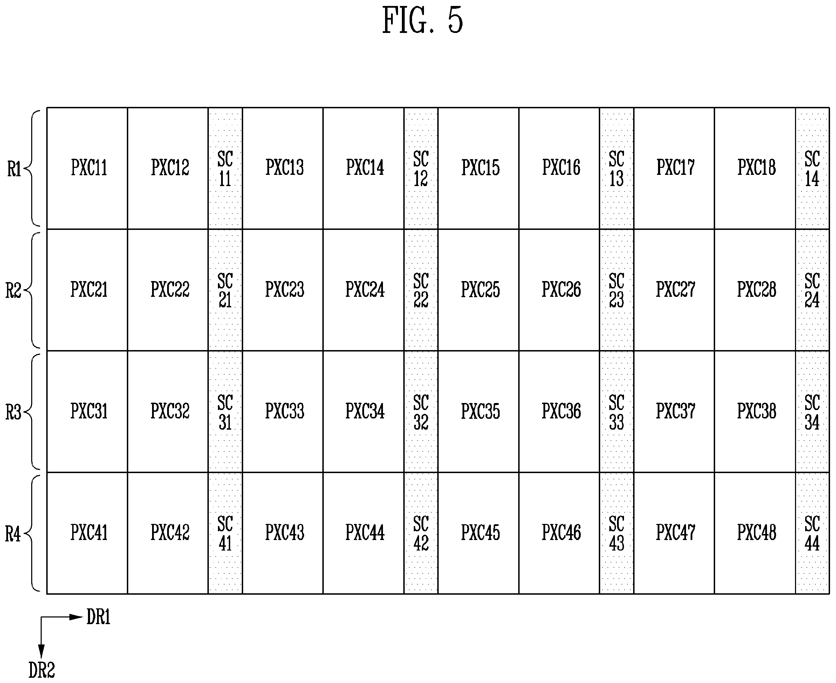

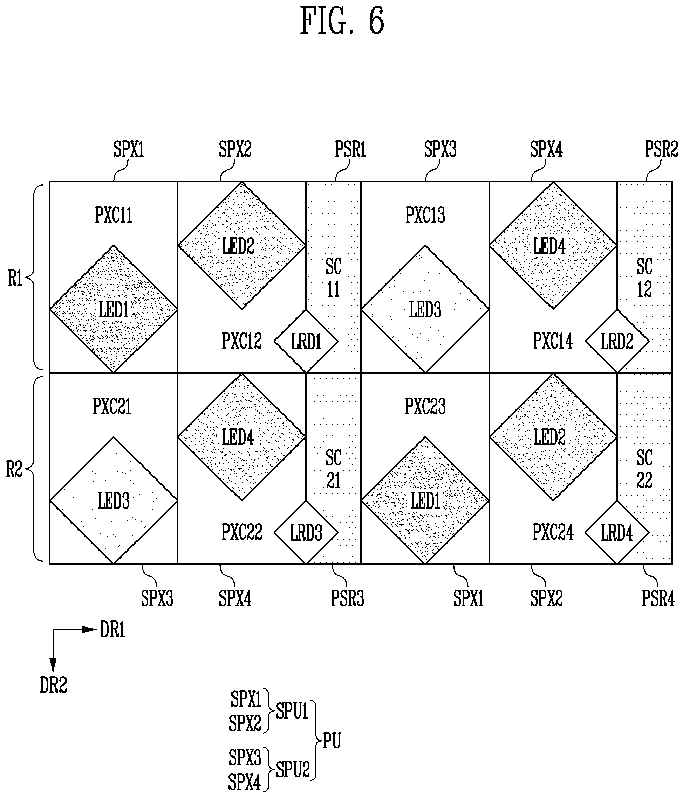

FIG. 5 is a schematic diagram illustrating an example of the arrangement of pixel circuits and sensor circuits in the display area of the display panel included in the display device of FIG. 2, and FIG. 6 is a schematic diagram illustrating an example of the display area of the display panel included in the display device of FIG. 2.

Referring to FIGS. 1 to 6, the sub-pixels SPX1 to SPX4 and the plurality of light-sensing pixels PSR1 to PSR4 may be located in the display area (see "DA" of FIG. 1) of the display panel (see "100" of FIG. 1).

The display area DA may be divided into pixel rows R1 to R4. Each of the pixel rows R1 to R4 may extend in the first direction DR1, and may be arranged in the second direction DR2. Each of the pixel rows R1 to R4 may include sub-pixels SPX1 to SPX4. Each of the sub-pixels SPX1 to SPX4 may include one of the pixel circuits PXC11 to PXC48 (e.g., PXC11 to PXC18, PXC21 to PXC28, PXC31 to PXC38, and PXC41 to PXC48) and one of the light-emitting elements LED1 to LED4.

In one or more embodiments, the first sub-pixel SPX1, the second sub-pixel SPX2, and the third sub-pixel SPX3 may emit light of a first color, light of a second color, and light of a third color, respectively. The light of the first color, the light of the second color, and the light of the third color may be lights of different colors. Each of the light of the first color, the light of the second color, and the light of the third color may be one of red light, green light, or blue light. A first light-emitting element LED1 that emits the light of the first color may be located in the first sub-pixel SPX1, a second light-emitting element LED2 that emits the light of the second color may be located in the second sub-pixel SPX2, a third light-emitting element LED3 that emits the light of the third color may be located in the third sub-pixel SPX3, and a fourth light-emitting element LED4 that emits the light of the second color may be located in the fourth sub-pixel SPX4. The second light-emitting element LED2 and the fourth light-emitting element LED4 may emit light of the same color.

In FIG. 6, each of the light-emitting elements LED1 to LED4 may be understood as an emission area corresponding to an emission layer. However, this is for convenience of explanation, and the color of the light emitted by each of the light-emitting elements LED1 to LED4 and the position, area, and shape of each of the light-emitting elements LED1 to LED4 are not limited thereto.

In one or more embodiments, in each of the odd-numbered pixel rows including the first pixel row R1 (or the first horizontal line) and the third pixel row R3 (or the third horizontal line), the sub-pixels SPX1 to SPX4 may be arranged in the first direction DR1 in the order of the first sub-pixel SPX1 emitting red light, the second sub-pixel SPX2 emitting green light, the third sub-pixel SPX3 emitting blue light, and the fourth sub-pixel SPX4 emitting green light.

In each of the even-numbered pixel rows including the second pixel row R2 (or the second horizontal line) and the fourth pixel row R4 (or the fourth horizontal line), the sub-pixels SPX1 to SPX4 may be arranged in the first direction DR1 in the order of the third sub-pixel SPX3, the fourth sub-pixel SPX4, the first sub-pixel SPX1, and the second sub-pixel SPX2.

In one or more embodiments, the first sub-pixel SPX1 and the second sub-pixel SPX2 may constitute a first sub-pixel unit SPU1, and the third sub-pixel SPX3 and the fourth sub-pixel SPX4 may constitute a second sub-pixel unit SPU2. In the odd-numbered pixel rows R1 and R3, the first sub-pixel unit SPU1 and the second sub-pixel unit SPU2 may be alternately arranged. In the even-numbered pixel rows R2 and R4, contrary to the odd-numbered pixel rows R1 and R3, the second sub-pixel unit SPU2 and the first sub-pixel unit SPU1 may be alternately arranged.

It may be understood that the first and second sub-pixel units SPU1 and SPU2 adjacent to each other constitute one pixel unit PU. For example, FIG. 6 illustrates the pixel units PU of the first pixel row R1 and the second pixel row R2. However, the present disclosure is not limited thereto, and the arrangement of the sub-pixels SPX1 to SPX4 may be variously changed.

In the first pixel row R1, pixel circuits PXC11 to PXC18 corresponding to the sub-pixels SPX1 to SPX4 of the first pixel row R1 may be arranged in the first direction DR1. In the second pixel row R2, pixel circuits PXC21 to PXC28 corresponding to the sub-pixels SPX1 to SPX4 of the second pixel row R2 may be arranged in the first direction DR1. In the third pixel row R3, pixel circuits PXC31 to PXC38 corresponding to the sub-pixels SPX1 to SPX4 of the third pixel row R3 may be arranged in the first direction DR1. In the fourth pixel row R4, pixel circuits PXC41 to PXC48 corresponding to the sub-pixels SPX1 to SPX4 of the fourth pixel row R4 may be arranged in the first direction DR1.

In FIG. 5, the first, second, third, and fourth pixel circuits PXC11, PXC12, PXC13, and PXC14 of the first pixel row R1 may be included in one pixel unit PU, and the fifth, sixth, seventh, and eighth pixel circuits PXC15, PXC16, PXC17, and PXC18 of the first pixel row R1 may be included in another pixel unit PU.

Similarly, the first to fourth pixel circuits PXC21 to PXC24 of the second pixel row R2, the fifth to eighth pixel circuits PXC25 to PXC28 of the second pixel row R2, the first to fourth pixel circuits PXC31 to PXC34 of the third pixel row R3, the fifth to eighth pixel circuits PXC35 to PXC38 of the third pixel row R3, the first to fourth pixel circuits PXC41 to PXC44 of the fourth pixel row R4, and the fifth to eighth pixel circuits PXC45 to PXC48 of the fourth pixel row R4 may be included in different respective pixel units PU.

In one or more embodiments, each of the pixel rows R1 to R4 may include light-receiving elements LRD1 to LRD4. In FIG. 6, each of the light-receiving elements LRD1 to LRD4 may be understood as a light-receiving area corresponding to a light-receiving layer. However, this is for convenience of explanation, and the positions, areas, and shapes of the light-receiving elements LRD1 to LRD4 may be variously changed.

The light-receiving elements LRD1 and LRD2 of the first pixel row R1 may overlap at least some of the pixel circuits PXC11 to PXC14 of the first pixel row R1 and the sensor circuits SC11 and SC12 of the first pixel row R1. The light-receiving elements LRD3 and LRD4 of the second pixel row R2 may overlap at least some of the pixel circuits PXC21 to PXC24 of the second pixel row R2 and the sensor circuits SC21 and SC22 of the second pixel row R2.

In one or more embodiments, the first light-receiving element LRD1 may overlap at least a portion of the first sensor circuit SC11 of the first pixel row R1, and the third light-receiving element LRD3 may overlap at least a portion of the first sensor circuit SC21 of the second pixel row R2.

The second light-receiving element LRD2 may overlap at least a portion of the second sensor circuit SC12 of the first pixel row R1, and the fourth light-receiving element LRD4 may overlap at least a portion of the second sensor circuit SC22 of the second pixel row R2.

The light-receiving elements LRD1 to LRD4 may be formed within the display area DA in the same arrangement as illustrated in FIG. 6, but the present disclosure is not limited thereto.

In one or more embodiments, the sensor circuits SC11 to SC44 (e.g., SC11 to SC14, SC21 to SC24, SC31 to SC34, and SC41 to SC44) may be electrically connected to the corresponding light-receiving elements. The first sensor circuit SC11 of the first pixel row R1 may be electrically connected to the first light-receiving element LRD1 to form a first light-sensing pixel PSR1. That is, the first sensor circuit SC11 and the first light-receiving element LRD1 may constitute the first light-sensing pixel PSR1. The second sensor circuit SC12 of the first pixel row R1 may be electrically connected to the second light-receiving element LRD2 to form a second light-sensing pixel PSR2. That is, the second sensor circuit SC12 and the second light-receiving element LRD2 may constitute the second light-sensing pixel PSR2. The first sensor circuit SC21 of the second pixel row R2 may be electrically connected to the third light-receiving element LRD3 to form a third light-sensing pixel PSR3. That is, the first sensor circuit SC21 and the third light-receiving element LRD3 may constitute the third light-sensing pixel PSR3. The second sensor circuit SC22 of the second pixel row R2 may be electrically connected to the fourth light-receiving element LRD4 to form a fourth light-sensing pixel PSR4. That is, the second sensor circuit SC22 and the fourth light-receiving element LRD4 may constitute the fourth light-sensing pixel PSR4. However, the present disclosure is not limited thereto. In accordance with one or more embodiments, only some of the sensor circuits SC11 to SC44 may be provided, and some of the sensor circuits SC11 to SC44 may be connected to a plurality of light-receiving elements.

The first sensor circuit SC11 of the first pixel row R1 may be located between the first sub-pixel unit SPU1 and the second sub-pixel unit SPU2 included in the pixel unit PU. For example, the first and second pixel circuits PXC11 and PXC12 of the first pixel row R1 may be included in the first sub-pixel unit SPU1, and the third and fourth pixel circuits PXC13 and PXC14 of the first pixel row R1 may be included in the second sub-pixel unit SPU2. Accordingly, at least two pixel circuits (e.g., PXC13 and PXC14) may be located between the first sensor circuit SC11 and the second sensor circuit SC12 adjacent to each other in the first pixel row R1.

Similar to the first sensor circuit SC11 of one pixel row R1, the second sensor circuit SC12 of the first pixel row R1, the first sensor circuit SC21 of the second pixel row R2, and the second sensor circuit SC22 of the second pixel row R2 may be located between the corresponding first sub-pixel unit SPU1 and the corresponding second sub-pixel unit SPU2.

FIG. 7 is a schematic circuit diagram illustrating an example of the sub-pixel SPX and the light-sensing pixel PSR included in the display area of FIG. 1. For convenience of explanation, FIG. 7 illustrates the sub-pixel SPX located on the i-th horizontal line (or the i-th pixel row) and connected to the j-th data line Dj.

Referring to FIGS. 1 and 7, the sub-pixel SPX and the light-sensing pixel PSR may be located on the i-th horizontal line.

The sub-pixel SPX may include a light-emitting element LED and a pixel circuit PXC. In one or more embodiments, the pixel circuit PXC may include first, second, third, fourth, fifth, sixth, seventh, and eighth transistors T1, T2, T3, T4, T5, T6, T7, and T8, a storage capacitor Cst, and a boost capacitor Cbst.

The first transistor T1 (or the driving transistor) may be electrically connected between a first power line PL1 and a first electrode (or an anode electrode) of the light-emitting element LED. The first transistor T1 may include a gate electrode electrically connected to a first node N1. The first transistor T1 may control an amount of current (or driving current) flowing from the first power line PL1 to an electrode EP (or a power line) via the light-emitting element LED based on a voltage of the first node N1. A first power supply voltage VDD may be supplied to the first power line PL1, a second power supply voltage VSS may be supplied to the electrode EP, and the first power supply voltage VDD may be set to be higher than the second power supply voltage VSS.

The second transistor T2 may be electrically connected between the j-th data line Dj and a second node N2. A gate electrode of the second transistor T2 may be connected to an 1i-th scan line S1i (or a first scan line). The second transistor T2 may be turned on in case that a first scan signal GW[i] (e.g., a first scan signal of a low level) is supplied to the 1i-th scan line S1i, and may electrically connect the j-th data line Dj to the second node N2. In case that each of the first transistor T1 and the third transistor T3 is turned on, the second transistor T2 may transmit a data signal of the j-th data line Dj to the second node N2 in response to the first scan signal GW[i].

The third transistor T3 may be electrically connected between the first node N1 and a third node N3. A gate electrode of the third transistor T3 may be electrically connected to a 4i-th scan line S4i (or a third scan line). The third transistor T3 may be turned on in case that a fourth scan signal GC[i] is supplied to the 4i-th scan line S4i.

The fourth transistor T4 may be electrically connected between the first node N1 and a second power line PL2. A gate electrode of the fourth transistor T4 may be electrically connected to a 2i-th scan line S2i (or a second scan line). A first initialization power supply voltage Vint1 may be supplied to the second power line PL2. The fourth transistor T4 may be turned on in response to a second scan signal GI[i] supplied to the 2i-th scan line S2i. In case that the fourth transistor T4 is turned on, the first initialization power supply voltage Vint1 may be supplied to the first node N1 (that is, the gate electrode of the first transistor T1).

The fifth transistor T5 may be electrically connected between the first power line PL1 and the second node N2. A gate electrode of the fifth transistor T5 may be electrically connected to an i-th emission control line Ei. The sixth transistor T6 may be electrically connected between the third node N3 and the light-emitting element LED (or a fourth node N4). A gate electrode of the sixth transistor T6 may be electrically connected to the i-th emission control line Ei. The fifth transistor T5 and the sixth transistor T6 may be turned on in case that an emission control signal EM[i] (e.g., an emission control signal EM[i] of a high level) is supplied to the i-th emission control line Ei, and may be turned off in other cases.

The seventh transistor T7 may be electrically connected between the first electrode (e.g., the fourth node N4) of the light-emitting element LED and a third power line PL3. A gate electrode of the seventh transistor T7 may be electrically connected to a 3i-th scan line S3i. A second initialization power supply voltage Vint2 may be supplied to the third power line PL3. In accordance with one or more embodiments, the second initialization power supply voltage Vint2 may be different from the first initialization power supply voltage Vint1. The seventh transistor T7 may be turned on in response to a third scan signal GB[i] supplied to the 3i-th scan line S3i and may supply the second initialization power supply voltage Vint2 to the first electrode of the light-emitting element LED.

The eighth transistor T8 may be electrically connected between the second node N2 and a fourth power line PL4. A gate electrode of the eighth transistor T8 may be electrically connected to the 3i-th scan line S3i. A bias voltage VOBS may be supplied to the fourth power line PL4. The eighth transistor T8 may be turned on in response to the third scan signal GB[i] supplied to the 3i-th scan line S3i and may supply the bias voltage VOBS to the second node N2.

The storage capacitor Cst may be connected or formed between the first power line PL1 and the first node N1.

The boost capacitor Cbst (or capacitor) may be connected or formed between the gate electrode of the second transistor T2 and the gate electrode of the first transistor T1.

The light-sensing pixel PSR may include a sensor circuit SC and a light-receiving element LRD. The sensor circuit SC may include ninth, tenth, and eleventh transistors T9, T10, and T11.

The ninth and eleventh transistors T9 and T11 may be connected in series between a sixth power line PL6 and a k-th readout line RXk (where k is a natural number).

The ninth transistor T9 (or the first sensor transistor) may be electrically connected between the sixth power line PL6 and the eleventh transistor T11. A gate electrode of the ninth transistor T9 may be electrically connected to a fifth node N5 (or a sensor node). The ninth transistor T9 may control a current flowing from the sixth power line PL6 to the k-th readout line RXk through the eleventh transistor T11 in response to a voltage of the fifth node N5. A common voltage VCOM may be supplied to the sixth power line PL6.

In accordance with one or more embodiments, the sixth power line PL6 may be electrically connected to or integrally formed with the third power line PL3, and the common voltage VCOM applied to the sixth power line PL6 may be the same as the second initialization power supply voltage Vint2, but the present disclosure is not limited thereto. In accordance with other embodiments, the sixth power line PL6 may be electrically connected to, or integrally formed with, the second power line PL2, and the common voltage VCOM applied to the sixth power line PL6 may be the same as the first initialization power supply voltage Vint1.

The eleventh transistor T11 (the "second sensor transistor" or the "switching transistor") may be electrically connected between the ninth transistor T9 and the k-th readout line RXk. A gate electrode of the eleventh transistor T11 may be connected to the 1i-th scan line S1i. That is, the gate electrode of the eleventh transistor T11 and the gate electrode of the second transistor T2 may share the 1i-th scan line S1i with each other.

The tenth transistor T10 (or the third sensor transistor) may be electrically connected between the fifth power line PL5 (or the reference power line) and the fifth node N5. A gate electrode of the tenth transistor T10 may be electrically connected to the reset line RSTL. A reset voltage VRST may be supplied to the fifth power line PL5. The reset voltage VRST may be a DC voltage having a constant level. For example, the reset voltage VRST may be about -7V, but the present disclosure is not limited thereto.

At least one light-receiving element LRD may be electrically connected between the fifth node N5 and the electrode EP to which the second power supply voltage VSS is applied.

The light-receiving element LRD may generate charges (or current) based on incident light. That is, the light-receiving element LRD may perform a photoelectric conversion function. For example, the light-receiving element LRD may be implemented as a photodiode.

In case that the tenth transistor T10 is turned on in response to the reset signal RST supplied to the reset line RSTL, the reset voltage VRST may be supplied to the fifth node N5. For example, the voltage of the fifth node N5 may be reset by the reset voltage VRST. After the reset voltage VRST is applied to the fifth node N5, the light-receiving element LRD may perform a photoelectric conversion function.

The voltage of the fifth node N5 may change due to the operation of the light-receiving element LRD. The voltage (or the charges or current generated in the light-receiving element LRD) of the fifth node N5 may change according to intensity of light incident on the light-receiving element LRD and the time for which the light is incident (or the time for which the light-receiving element LRD is exposed to light).

In case that the eleventh transistor T11 is turned on in response to the first scan signal GW[i] supplied to the first scan line S1i, the detection value (current and/or voltage) generated based on the voltage of the fifth node N5 may flow to the k-th readout line RXk.

In one or more embodiments, each of the pixel circuit PXC and the sensor circuit SC may include a P-type transistor and an N-type transistor. Each of the third transistor T3, the fourth transistor T4, and the tenth transistor T10 may be formed using an oxide semiconductor transistor including an oxide semiconductor (or a second-type semiconductor). For example, each of the third transistor T3, the fourth transistor T4, and the tenth transistor T10 may be an N-type oxide semiconductor transistor and may include an oxide semiconductor layer as an active layer, but the present disclosure is not limited thereto.

Each of the remaining transistors (e.g., the first, second, fifth, sixth, seventh, eighth, ninth, and eleventh transistors T1, T2, T5, T6, T7, T8, T9 and T11) may be formed using a poly-silicon transistor including a silicon semiconductor (or, a first-type semiconductor), and may include a poly-silicon semiconductor layer as an active layer. For example, the active layer may be formed through a low-temperature poly-silicon (LTPS) process.

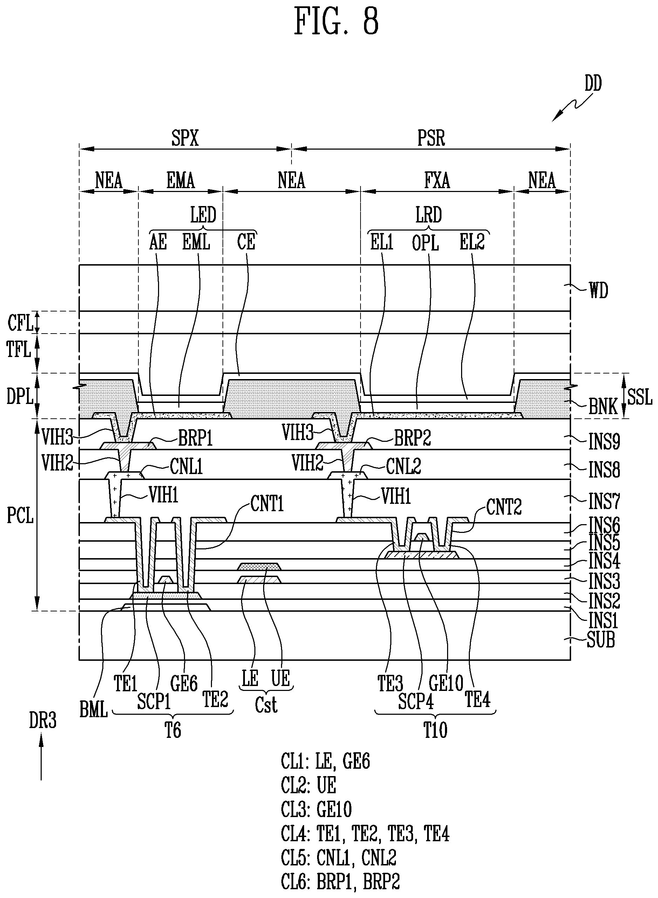

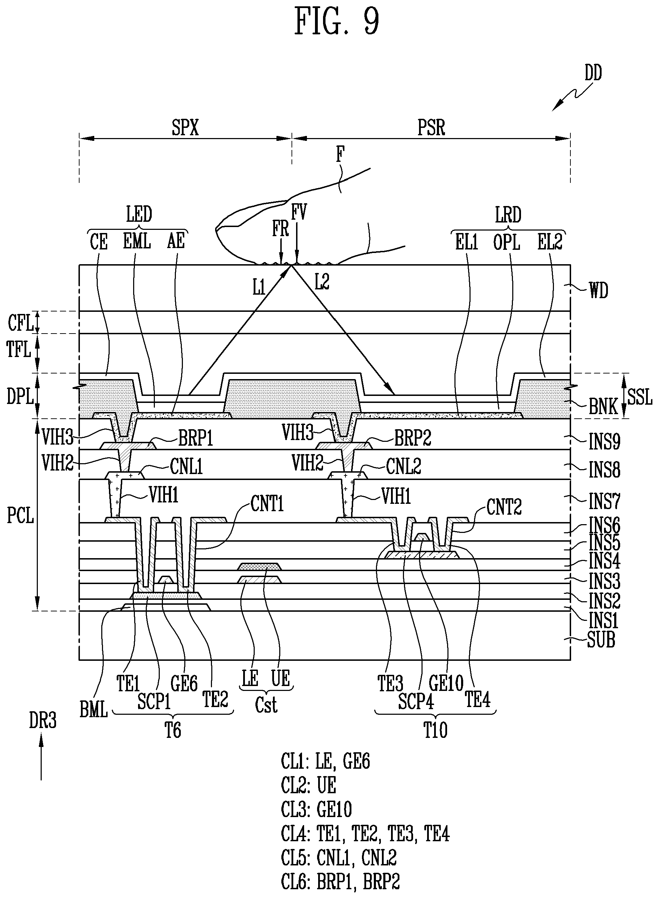

The following description will be given with reference to FIGS. 8 and 9, focusing on a stacked structure (or a cross-sectional structure) of the sub-pixel SPX including the light-emitting element LED and the light-sensing pixel PSR including the light-receiving element LRD.

FIG. 8 is a schematic cross-sectional view illustrating one region of a display device DD in accordance with one or more embodiments, and FIG. 9 is a schematic cross-sectional view illustrating a reflection path of light in the display device of FIG. 8.

FIGS. 8 and 9 illustrate the cross section of a portion corresponding to the sixth transistor T6 among the first to eighth transistors T1 to T8 illustrated in FIG. 7, and the cross section of a portion corresponding to the tenth transistor T10 among the ninth to eleventh transistors T9 to T11.

Referring to FIGS. 1 to 9, the display device DD may include the sub-pixel SPX and the light-sensing pixel PSR provided in one region of the substrate SUB.

The pixel circuit layer PCL of the sub-pixel SPX and the pixel circuit layer PCL of the light-sensing pixel PSR may be located on the substrate SUB. At least one insulating layer may be located on the pixel circuit layer PCL. The insulating layer may include a first insulating layer INS1, a second insulating layer INS2, a third insulating layer INS3, a fourth insulating layer INS4, a fifth insulating layer INS5, a sixth insulating layer INS6, a seventh insulating layer INS7, an eighth insulating layer INS8, and a ninth insulating layer INS9, which are sequentially stacked on the substrate SUB along the third direction DR3.

The first insulating layer INS1 (or buffer layer) may be located on the substrate SUB. The first insulating layer INS1 may reduce or prevent impurities diffusing into the sixth transistor T6 and the tenth transistor T10. The first insulating layer INS1 may be an inorganic layer including an inorganic material (or substance). The first insulating layer INS1 may include at least one of silicon nitride (SiNₓ), silicon oxide (SiOₓ), silicon oxynitride (SiOₓN_{y}), or aluminum oxide (AlOₓ). The first insulating layer INS1 may be provided as a single layer and may also be provided as a multilayer of at least two layers. The first insulating layer INS1 may be omitted according to the material and process conditions of the substrate SUB.

The second insulating layer INS2 (or first gate insulating layer) may be located on the first insulating layer INS1. The second insulating layer INS2 may include the same material as the first insulating layer INS1 or may include a material suitable for (or selected from) materials provided as an example of the constituent materials of the first insulating layer INS1. For example, the second insulating layer INS2 may be an inorganic layer including an inorganic material.

The third insulating layer INS3 (or second gate insulating layer) may be located on the second insulating layer INS2. The third insulating layer INS3 may include the same material as the first insulating layer INS1 or may include a material suitable for (or selected from) materials provided as an example of the constituent materials of the first insulating layer INS1.

The fourth insulating layer INS4 (or first interlayer insulating layer) may be located on the third insulating layer INS3. The fourth insulating layer INS4 may be an inorganic layer including an inorganic material or an organic layer including an organic material.

The fifth insulating layer INS5 (or third gate insulating layer) may be located on the fourth insulating layer INS4. The fifth insulating layer INS5 may be an inorganic layer including an inorganic material or an organic layer including an organic material.

The sixth insulating layer INS6 (or second interlayer insulating layer) may be located on the fifth insulating layer INS5. The sixth insulating layer INS6 may be an inorganic layer including an inorganic material or an organic layer including an organic material.

The seventh insulating layer INS7 (or first via layer) may be located on the sixth insulating layer INS6. The seventh insulating layer INS7 may be an inorganic layer including an inorganic material or an organic layer including an organic material. The inorganic layer may include, for example, at least one of silicon oxide (SiOₓ), silicon nitride (SiNₓ), silicon oxynitride (SiOₓN_{y}), or aluminum oxide (AlOₓ). The organic layer may include, for example, polyacrylates resin, epoxy resin, phenolic resin, polyamides resin, polyimides rein, unsaturated polyesters resin, polyphenylenethers resin, polyphenylenesulfides resin, or benzocyclobutene resin. In one or more embodiments, the seventh insulating layer INS7 may be an organic layer.

The eighth insulating layer INS8 (or second via layer) may be located on the seventh insulating layer INS7. The eighth insulating layer INS8 may include the same material as the seventh insulating layer INS7 or may include a material suitable for (or selected from) materials provided as an example of the constituent materials of the seventh insulating layer INS7. For example, the eighth insulating layer INS8 may be an organic layer including an organic material.

The ninth insulating layer INS9 (or third via layer) may be located on the eighth insulating layer INS8. The ninth insulating layer INS9 may include the same material as the seventh insulating layer INS7 or may include a material suitable for (or selected from) materials provided as an example of the constituent materials of the seventh insulating layer INS7. For example, the ninth insulating layer INS9 may be an organic layer including an organic material.

The pixel circuit layer PCL may include at least one conductive layer located between the insulating layers described above. For example, the conductive layers may include a first conductive layer CL1 located between the second insulating layer INS2 and the third insulating layer INS3, a second conductive layer CL2 located between the third insulating layer INS3 and the fourth insulating layer INS4, a third conductive layer CL3 located between the fifth insulating layer INS5 and the sixth insulating layer INS6, a fourth conductive layer CL4 located between the sixth insulating layer INS6 and the seventh insulating layer INS7, a fifth conductive layer CL5 located between the seventh insulating layer INS7 and the eighth insulating layer INS8, and a sixth conductive layer CL6 located between the eighth insulating layer INS8 and the ninth insulating layer INS9. The insulating layers and the conductive layers are not limited to the embodiments described above. In accordance with one or more embodiments, other insulating layers and other conductive layers in addition to the insulating layers and the conductive layers may be located in the pixel circuit layer PCL.

In one or more embodiments, a first semiconductor layer may be located between the first insulating layer INS1 and the second insulating layer INS2. The first semiconductor layer may include a silicon semiconductor. For example, the silicon semiconductor may include amorphous silicon, polycrystalline silicon, etc. The first semiconductor layer may include low-temperature polysilicon, but the present disclosure is not limited thereto. The first semiconductor layer may include a first semiconductor region with high conductivity and a second semiconductor region with low conductivity. The first semiconductor region may be doped with an N-type dopant or a P-type dopant. A P-type transistor may include a doped region doped with a P-type dopant, and an N-type transistor may include a doped region doped with an N-type dopant. The second semiconductor region may be a non-doped region, or may be a region doped at a lower concentration than the first semiconductor region. The conductivity of the first semiconductor region may be greater than the conductivity of the second semiconductor region. The first semiconductor region may substantially serve as an electrode or a signal line. The second semiconductor region may substantially correspond to an active pattern (or channel region) of the transistor. A portion of the first semiconductor layer may be an active pattern region of the transistor, another portion of the first semiconductor layer may be a source/drain region (or source/drain electrode) of the transistor, and another portion of the first semiconductor layer may be a connection electrode or a connection signal line, but the present disclosure is not limited thereto.

In one or more embodiments, a second semiconductor layer may be located between the fourth insulating layer INS4 and the fifth insulating layer INS5. The second semiconductor layer may include an oxide semiconductor. The oxide semiconductor may include a plurality of regions divided according to whether a metal oxide has been reduced. A region in which the metal oxide has been reduced (hereinafter referred to as a "reduced region") may have greater conductivity than a region in which the metal oxide has not been reduced (hereinafter referred to as a "non-reduced region"). The reduced region may actually be used as the source/drain region of the transistor or the signal line. The non-reduced region may substantially correspond to the active pattern (or channel region) of the transistor. A portion of the second semiconductor layer may be the active pattern of the transistor, another portion of the second semiconductor layer may be the source/drain region (or source/drain electrode) of the transistor, and another portion of the second semiconductor layer may be the signal transmission region, but the present disclosure is not limited thereto.

The sixth transistor T6 and the tenth transistor T10 may be located in the pixel circuit layer PCL.

The sixth transistor T6 may include a gate electrode GE6 (hereinafter referred to as a "sixth gate electrode"), a first semiconductor pattern SCP1, a first terminal TE1, and a second terminal TE2. The tenth transistor T10 may include a gate electrode GE10 (hereinafter referred to as a "tenth gate electrode"), a fourth semiconductor pattern SCP4, a third terminal TE3, and a fourth terminal TE4.

The first semiconductor pattern SCP1 may be located on the first insulating layer INS1, and may include the first semiconductor layer. The first semiconductor pattern SCP1 may include a channel region, a first contact region connected to one end of the channel region, and a second contact region connected to the other end of the channel region. The second insulating layer INS2 may be located on the first semiconductor pattern SCP1.

The sixth gate electrode GE6 may be located on the second insulating layer INS2, and may be of the first conductive layer CL1. The first conductive layer CL1 may include a single layer or multiple layers formed of molybdenum, copper, chromium, gold, silver, titanium, nickel, neodymium, indium, tin, and/or any oxide or alloy thereof. For example, the first conductive layer CL1 may include multiple layers in which titanium, copper, and/or indium tin oxide are sequentially or repeatedly stacked, but the present disclosure is not limited thereto. The sixth gate electrode GE6 may overlap one region of the first semiconductor pattern SCP1. One region of the first semiconductor pattern SCP1 that overlaps the sixth gate electrode GE6 may be the channel region of the sixth transistor T6. The third insulating layer INS3 may be located on the sixth gate electrode GE6.

The first terminal TE1 and the second terminal TE2 may be located on the sixth insulating layer INS6. The first terminal TE1 and the second terminal TE2 may be of the fourth conductive layer CL4. The fourth conductive layer CL4 may include a single layer or multiple layers formed of molybdenum, copper, aluminum, chromium, gold, silver, titanium, nickel, neodymium, indium, tin, and/or any oxide or alloy thereof.

The first terminal TE1 may be electrically connected to the second contact region of the first semiconductor pattern SCP1 through a first contact portion CNT1 that passes through the second insulating layer INS2, the third insulating layer INS3, the fourth insulating layer INS4, the fifth insulating layer INS5, and the sixth insulating layer INS6. The first terminal TE1 may be electrically connected to the anode electrode AE of the light-emitting element LED. The second terminal TE2 may be electrically connected to the first contact region of the first semiconductor pattern SCP1 through another first contact portion CNT1 that passes through the second insulating layer INS2, the third insulating layer INS3, the fourth insulating layer INS4, the fifth insulating layer INS5, and the sixth insulating layer INS6.

The seventh insulating layer INS7 may be located on the first terminal TE1 and the second terminal TE2.

The fourth semiconductor pattern SCP4 may be located on the fourth insulating layer INS4. The fourth semiconductor pattern SCP4 may be of the second semiconductor layer. The fourth semiconductor pattern SCP4 may include a channel region, a first contact region connected to one end of the channel region, and a second contact region connected to the other end of the channel region. The fifth insulating layer INS5 may be located on the fourth semiconductor pattern SCP4.

The tenth gate electrode GE10 may be located on the fifth insulating layer INS5. The tenth gate electrode GE10 may be of the third conductive layer CL3. The third conductive layer CL3 may include the same material as the first conductive layer CL1 or the fourth conductive layer CL4, or may include a material suitable for (or selected from) materials provided as an example of the constituent materials of the first conductive layer CL1 or the fourth conductive layer CL4. The tenth gate electrode GE10 may overlap one region of the fourth semiconductor pattern SCP4. One region of the fourth semiconductor pattern SCP4 that overlaps the tenth gate electrode GE10 may be the channel region of the tenth transistor T10.

The sixth insulating layer INS6 may be located on the tenth gate electrode GE10.

The third terminal TE3 and the fourth terminal TE4 may be located on the sixth insulating layer INS6. The third terminal TE3 and the fourth terminal TE4 may be of the the fourth conductive layer CL4.

The third terminal TE3 may be electrically connected to the first contact region of the fourth semiconductor pattern SCP4 through a second contact portion CNT2 that passes through the fifth insulating layer INS5 and the sixth insulating layer INS6. The fourth terminal TE4 may be electrically connected to the second contact region of the fourth semiconductor pattern SCP4 through another second contact portion CNT2 that passes through the fifth insulating layer INS5 and the sixth insulating layer INS6. The third terminal TE3 and the fourth terminal TE4 may be spaced from each other on the sixth insulating layer INS6. The seventh insulating layer INS7 may be located on the third terminal TE3 and the fourth terminal TE4.

In accordance with one or more embodiments, the pixel circuit layer PCL may further include a bottom metal pattern BML located on the substrate SUB. The bottom metal pattern BML may overlap the sixth transistor T6. In accordance with one or more embodiments, the bottom metal pattern BML may be electrically connected to the sixth transistor T6 to stabilize the channel region of the sixth transistor T6.

A storage capacitor Cst may be located on the pixel circuit layer PCL. The storage capacitor Cst may include a lower electrode LE and an upper electrode UE.

The lower electrode LE may be located on the second insulating layer INS2. The lower electrode LE may include the first conductive layer CL1, and may be provided on the same layer as the sixth gate electrode GE6, but the present disclosure is not limited thereto. The third insulating layer INS3 may be located on the lower electrode LE.

The upper electrode UE may be located on the third insulating layer INS3. The upper electrode UE may be part of the second conductive layer CL2, but the present disclosure is not limited thereto. The second conductive layer CL2 may include the same material as the first conductive layer CL1 or the fourth conductive layer CL4, or may include at least one material suitable for (or selected from) materials provided as an example of the constituent materials of the first conductive layer CL1 or the fourth conductive layer CL4. The upper electrode UE may form a capacitance by overlapping the lower electrode LE with the third insulating layer INS3 therebetween.

A first connection line CNL1, a second connection line CNL2, a first bridge pattern BRP1, and a second bridge pattern BRP2 may be located on the pixel circuit layer PCL.

The first connection line CNL1 and the second connection line CNL2 may be located on the seventh insulating layer INS7. The first connection line CNL1 and the second connection line CNL2 may be part of the fifth conductive layer CL5. The fifth conductive layer CL5 may include the same material as the first conductive layer CL1 or the fourth conductive layer CL4, or may include at least one material suitable for (or selected from) materials provided as an example of the constituent materials of the first conductive layer CL1 or the fourth conductive layer CL4. The first connection line CNL1 may be electrically connected to the first terminal TE1 of the sixth transistor T6 through a first via hole VIH1 that passes through the seventh insulating layer INS7. The second connection line CNL2 may be electrically connected to the third terminal TE3 of the tenth transistor T10 through another first via hole VIH1 that passes through the seventh insulating layer INS7. The eighth insulating layer INS8 may be located on the first connection line CNL1 and the second connection line CNL2.

The first bridge pattern BRP1 and the second bridge pattern BRP2 may be located on the eighth insulating layer INS8. The first bridge pattern BRP1 and the second bridge pattern BRP2 may be part of the sixth conductive layer CL6. The sixth conductive layer CL6 may include the same material as the first conductive layer CL1 or the fourth conductive layer CL4, or may include at least one material suitable for (or selected from) materials provided as an example of the constituent materials of the first conductive layer CL1 or the fourth conductive layer CL4. The first bridge pattern BRP1 may be electrically connected to the first connection line CNL1 through a second via hole VIH2 that passes through the eighth insulating layer INS8. The second bridge pattern BRP2 may be electrically connected to the second connection line CNL2 through another second via hole VIH2 that passes through the eighth insulating layer INS8. The ninth insulating layer INS9 may be located on the first and second bridge patterns BRP1 and BRP2.

A display element layer DPL may be located on the pixel circuit layer PCL of the sub-pixel SPX, and a sensor layer SSL may be located on the pixel circuit layer PCL of the light-sensing pixel PSR.

A light-emitting element LED and a bank BNK may be located on the display device layer DPL. The light-emitting element LED may include an anode electrode AE (or pixel electrode), an emission layer EML, and a cathode electrode CE (or common electrode). The light-emitting element LED may be electrically connected to the sixth transistor T6 through the first bridge pattern BRP1 and the first connection line CNL1. The light-emitting element EML may include a hole transport layer, an organic material layer (or a light generating layer), an electron transport layer, etc.

A light-receiving element LRD and a bank BNK may be located in the sensor layer SSL. The light-receiving element LRD may be an optical fingerprint sensor. The light-receiving element LRD may recognize a fingerprint by sensing light reflected from ridges FR of a finger F, and from valleys FV between the ridges FR. For example, in case that the user's finger F touches a window WD, first light L1 output from the light-emitting element LED (or emission layer EML) may be reflected from the ridges FR of the finger F or the valleys FV, and reflected second light L2 may reach the light-receiving element LRD (or light-receiving layer OPL) of the sensor layer SSL. The light-receiving element LRD may recognize the pattern of the user's fingerprint by distinguishing between second light L2 reflected from the ridges FR of the finger F and second light L2 reflected from the valleys FV of the finger F. The light-receiving element LRD may be electrically connected to the tenth transistor T10. The light-receiving element LRD may include a first electrode EL1 (or a first sensor electrode), a light-receiving layer OPL (or a photoelectric conversion layer), and a second electrode EL2 (or a second sensor electrode).

The anode electrode AE and the first electrode EL1 may be located on the ninth insulating layer INS9. Each of the anode electrode AE and the first electrode EL1 may include a metal layer, such as silver, magnesium, aluminum, platinum, palladium, gold, nickel, neodymium, iridium, chromium, or any alloy thereof, and/or indium tin oxide (ITO), indium zinc oxide (IZO), zinc oxide (ZnO), indium tin zinc oxide (ITZO), etc., but the present disclosure is not limited thereto. The anode electrode AE may be electrically connected to the first bridge pattern BRP1 through a third via hole VIH3 that passes through the ninth insulating layer INS9. The first electrode EL1 may be electrically connected to the second bridge pattern BRP2 through another third via hole VIH3 that passes through the ninth insulating layer INS9.

The anode electrode AE and the first electrode EL1 may be formed substantially simultaneously or sequentially through patterning using a mask.

The bank BNK may be a pixel-defining layer that defines (or partitions) the emission area EMA of the sub-pixel SPX and the light-receiving area FXA of the light-sensing pixel PSR. The bank BNK may be an organic layer including an organic material (or substance). The organic material may include acryl resin, epoxy resin, phenolic resin, polyamide resin, polyimide resin, etc. The bank BNK may be located on the ninth insulating layer INS9 in the non-emission area NEA of the sub-pixel SPX and the light-sensing pixel PSR.

In accordance with one or more embodiments, the bank BNK may include a light-absorbing material or may be coated with a light-absorbing material to absorb light introduced from the outside. For example, the bank BNK may include a carbon-based black pigment, but the present disclosure is not limited thereto. The bank BNK may include an opaque metallic material, such as chromium, molybdenum, alloys of molybdenum and titanium, tungsten, vanadium, niobium, tantalum, manganese, cobalt, or nickel, which has high light absorptance. The bank BNK may include openings corresponding to the emission area EMA and the light-receiving area FXA.

The emission layer EML may be located on the anode electrode AE. The emission layer EML may include an organic emission layer. The emission layer EML may emit light, such as red light, green light, or blue light according to the organic material included in the emission layer EML, but the present disclosure is not limited thereto.

The light-receiving layer OPL may be located on the first electrode EL1. The light-receiving layer OPL may sense the intensity of light by emitting electrons in response to light in a corresponding wavelength band.

The light-receiving layer OPL may include a low molecular weight organic material (or substance). For example, the light-receiving layer OPL may be formed of a phthalocyanines compound including one or more metals selected from the group consisting of copper (Cu), iron (Fe), nickel (Ni), cobalt (Co), manganese (Mn), aluminum (Al), palladium (Pd), tin (Sn), Indium (In), lead (Pb), titanium (Ti), rubidium (Rb), vanadium (V), gallium (Ga), terbium (Tb), cerium (Ce), lanthanum (La), or zinc (Zn).

Alternatively, the low molecular weight organic material included in the light-receiving layer OPL may include a bi-layer including a layer a phthalocyanines compound including one or more metals selected from the group consisting of copper (Cu), iron (Fe), nickel (Ni), cobalt (Co), manganese (Mn), aluminum (Al), palladium (Pd), tin (Sn), Indium (In), lead (Pb), titanium (Ti), rubidium (Rb), vanadium (V), gallium (Ga), terbium (Tb), cerium (Ce), lanthanum (La), or zinc (Zn) and a layer including C60, or may include one mixing layer in which a phthalocyanines compound and C60 are mixed. However, the present disclosure is not limited to the embodiments described above. In accordance with one or more embodiments, the light-receiving layer OPL may include a high molecular weight organic layer.

The cathode electrode CE may be located on the emission layer EML, and the second electrode EL2 may be located on the emission layer OPL. The cathode electrode CE and the second electrode EL2 may be a common electrode integrally formed in the display area DA. The second power supply voltage VSS may be supplied to the cathode electrode CE and the second electrode EL2.

Each of the cathode electrode CE and the second electrode EL2 may include a metal layer, such as Ag, Mg, Al, Pt, Pd, Au, Ni, Nd, Ir, or Cr, and/or a transparent conductive layer, such as ITO, IZO, ZnO, or ITZO. In one or more embodiments, the cathode electrode CE and the second electrode EL2 may include multiple layers of two or more layers including a metal thin-film layer, for example, a triple layer of ITO/Ag/ITO.

A thin-film encapsulation layer TFL may be formed entirely on the cathode electrode CE and the second electrode EL2.

The thin-film encapsulation layer TFL may include a single layer and may also include multiple layers. The thin-film encapsulation layer TFL may include a plurality of insulating layers covering the light-emitting element LED and the light-receiving element LRD. For example, the thin-film encapsulation layer TFL may include at least one inorganic layer and at least one organic layer. For example, the thin-film encapsulation layer TFL may have a structure in which inorganic layers and organic layers are alternately stacked.

A color filter layer CFL may be located on the thin-film encapsulation layer TFL. The color filter layer CFL may include a light-blocking pattern and a color filter. The light-blocking pattern may be located on the thin-film encapsulation layer TFL to correspond to the non-emission area NEA surrounding the emission area EMA of the sub-pixel SPX and the light-receiving area FXA of the light-sensing pixel PSR, and the color filter may be located on the thin-film encapsulation layer TFL to correspond to the emission area EMA and the light-receiving area FXA. The color filter layer CFL described above may also be used as an antireflection layer that blocks external light reflection.

The window WD may be located on the color filter layer CFL. The window WD may protect the exposed surface of the display device DD (or the display panel (see "100" of FIG. 1)). The window WD may protect the display device DD from external impact, and may provide an input surface and/or a display surface to a user. The window WD (or the cover glass) may have a multilayer structure selected from a glass substrate, a plastic film, and a plastic substrate. This multilayer structure may be formed through a continuous process or an adhesion process using an adhesive layer. The window WD may be fully or partially flexible.

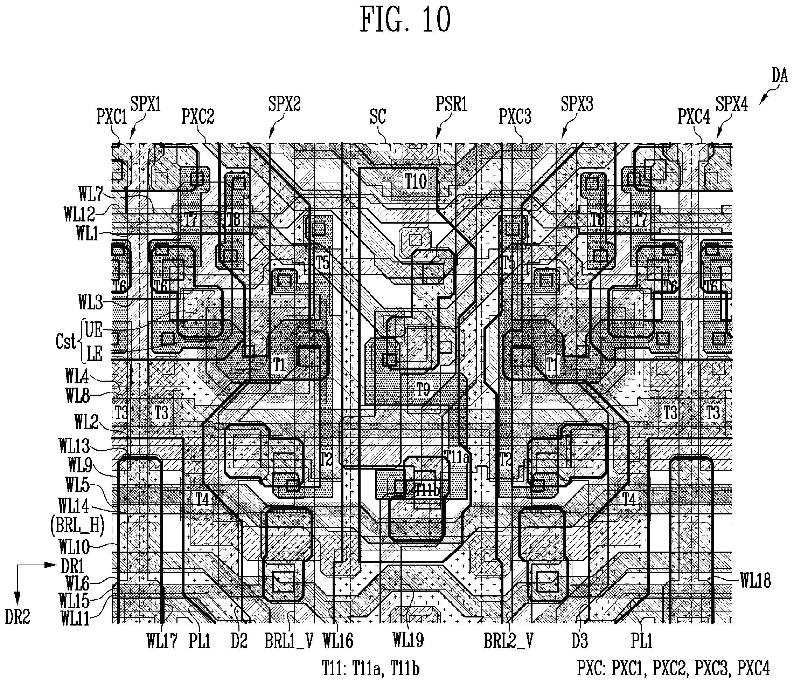

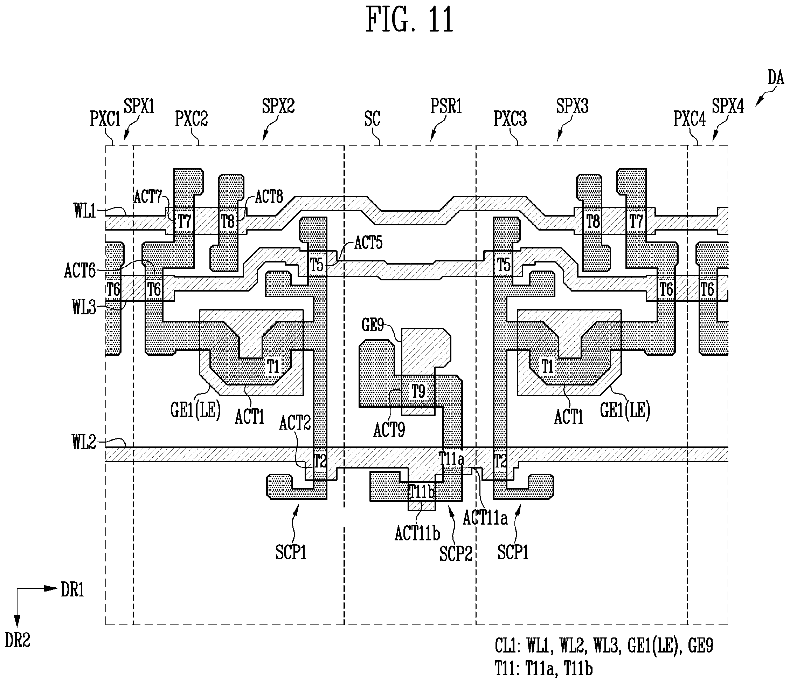

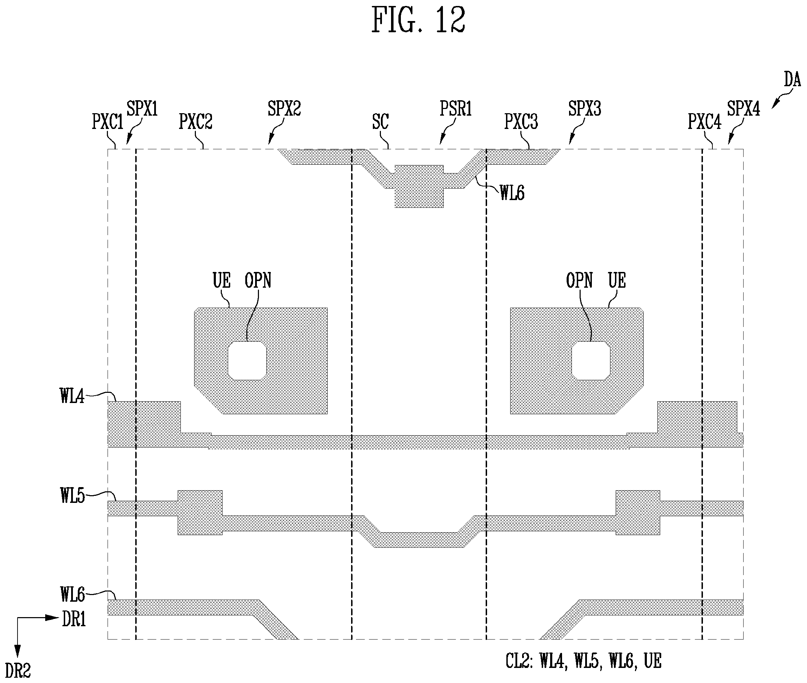

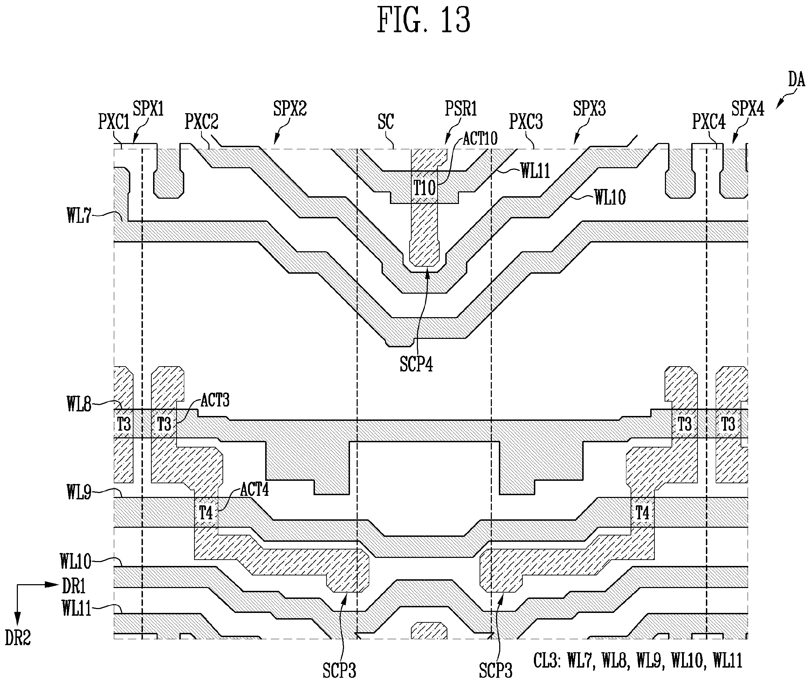

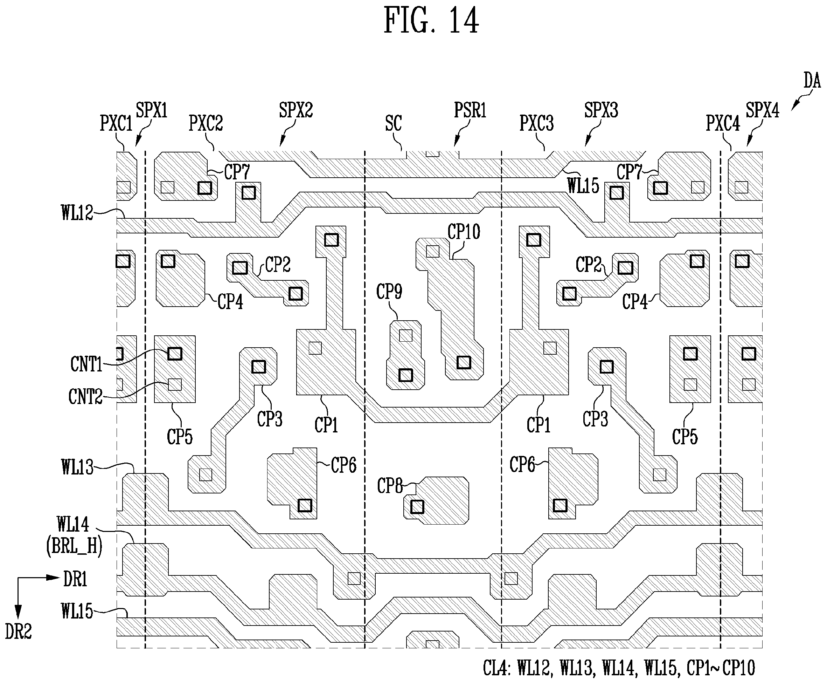

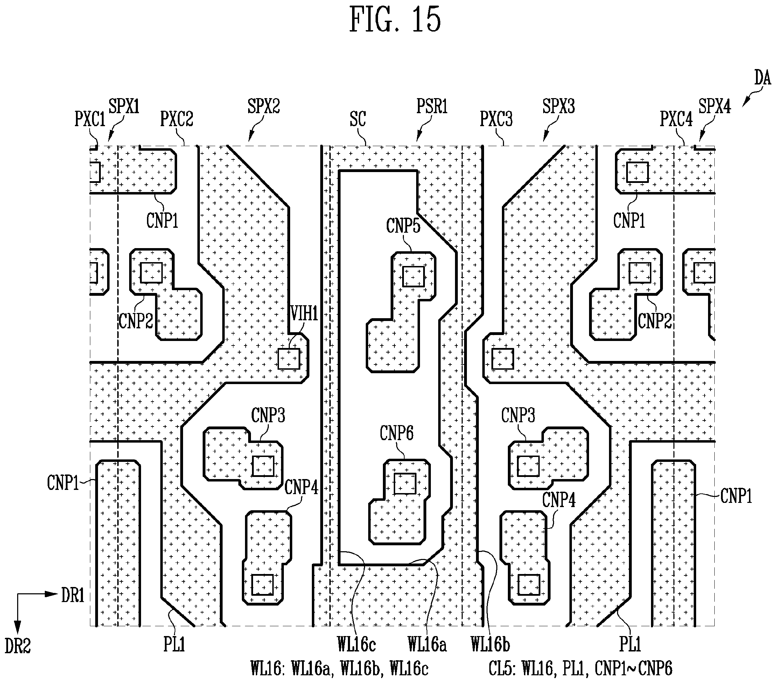

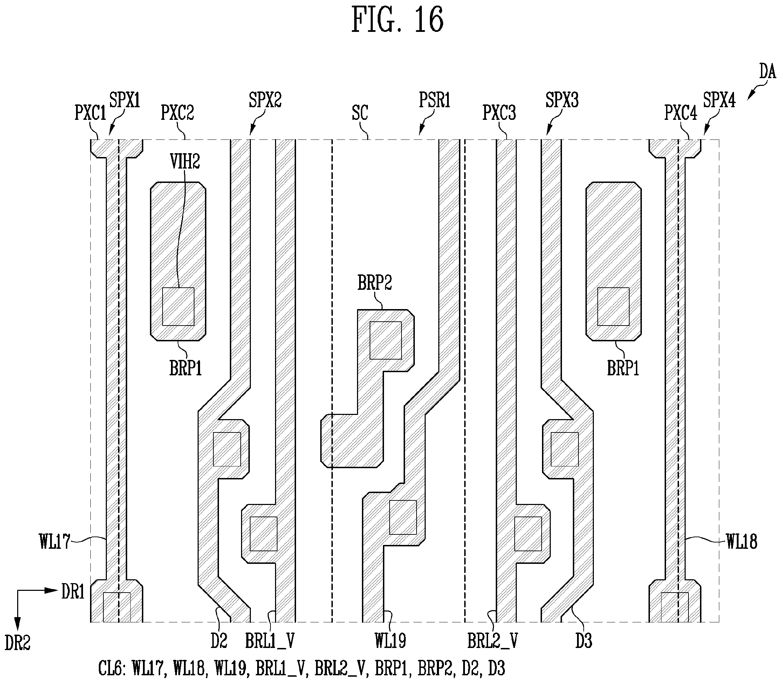

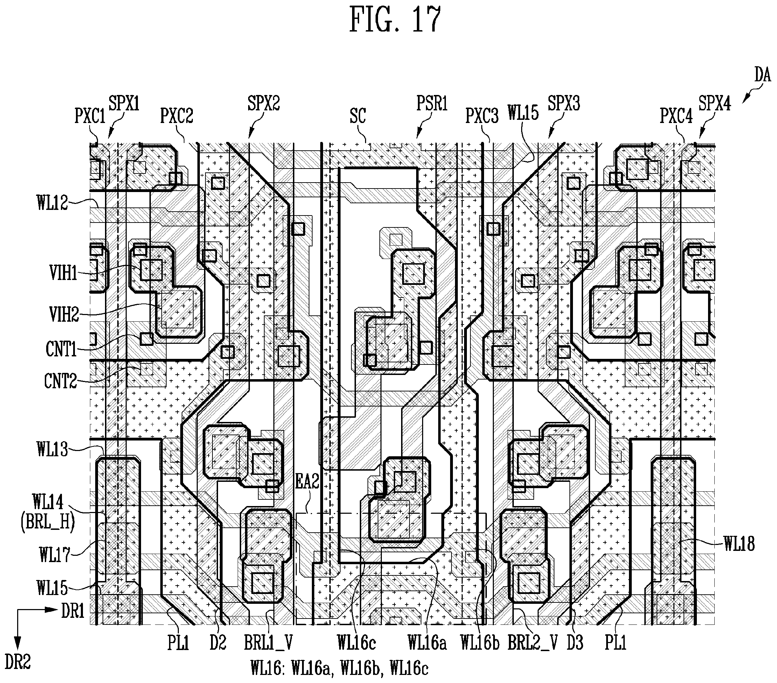

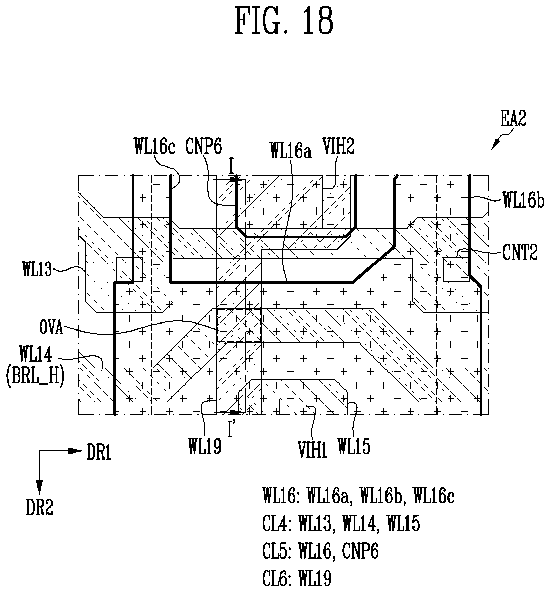

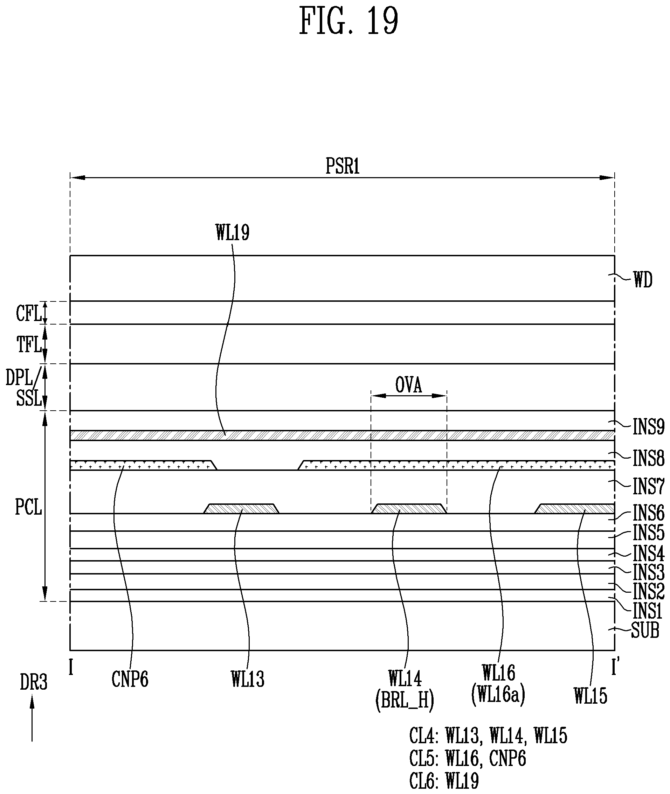

FIG. 10 is a schematic plan view illustrating the sub-pixels SPX1 to SPX4 and the first light-sensing pixel PSR1 in accordance with one or more embodiments. FIG. 11 is a schematic plan view illustrating only the first, second, fifth, sixth, seventh, eighth, ninth, and eleventh transistors T1, T2, T5, T6, T7, T8, T9, and T11 and components included in the first conductive layer CL1 in FIG. 10. FIG. 12 is a schematic plan view illustrating only components included in the second conductive layer CL2 in FIG. 10. FIG. 13 is a schematic plan view illustrating only the third, fourth, and tenth transistors T3, T4, and T10 and components included in the third conductive layer CL3 in FIG. 10. FIG. 14 is a schematic plan view illustrating only components included in the fourth conductive layer CL4 in FIG. 10. FIG. 15 is a schematic plan view illustrating only components included in the fifth conductive layer CL5 in FIG. 10. FIG. 16 is a schematic plan view illustrating only components included in the sixth conductive layer CL6 in FIG. 10. FIG. 17 is a schematic plan view illustrating only components included in the fourth conductive layer, the fifth conductive layer, and the sixth conductive layer in FIG. 10. FIG. 18 is a schematic enlarged view illustrating a region EA2 of FIG. 17. FIG. 19 is a schematic cross-sectional view taken along the line I-I' of FIG. 18.

In FIGS. 10 to 19, for convenience of explanation, the first sub-pixel SPX1, the second sub-pixel SPX2, the third sub-pixel SPX3, the fourth sub-pixel SPX4, and the first light-sensing pixel PSR1 arranged in the same pixel row (or the same horizontal line) are illustrated.

Referring to FIGS. 10 to 19, the first sub-pixel SPX1, the second sub-pixel SPX2, the third sub-pixel SPX3, and the fourth sub-pixel SPX4 may be arranged along the first direction DR1 in the display area DA. The first light-sensing pixel PSR1 may be located between the second sub-pixel SPX2 and the third sub-pixel SPX3. For example, the first sub-pixel SPX1, the second sub-pixel SPX2, the first light-sensing pixel PSR1, the third sub-pixel SPX3, and the fourth sub-pixel SPX4 may be arranged in the display area DA (or the first pixel row (see "R1" of FIG. 6) of the substrate SUB).

Each of the first to fourth sub-pixels SPX1 to SPX4 may include a pixel circuit PXC. For example, the first sub-pixel SPX1 may include a first pixel circuit PXC1, the second sub-pixel SPX2 may include a second pixel circuit PXC2, the third sub-pixel SPX3 may include a third pixel circuit PXC3, and the fourth sub-pixel SPX4 may include a fourth pixel circuit PXC4. The first light-sensing pixel PSR1 may include a sensor circuit SC. The first pixel circuit PXC1 may correspond to an eleventh pixel circuit PXC11 of FIG. 6, the second pixel circuit PXC2 may corresponds to a twelfth pixel circuit PXC12 of FIG. 6, the third pixel circuit PXC3 may correspond to a thirteenth pixel circuit PXC13 of FIG. 6, the fourth pixel circuit PXC4 may correspond to a fourteenth pixel circuit PXC14 of FIG. 6, and the sensor circuit SC may correspond to an eleventh sensor circuit SC11 of FIG. 6. With respect to the sensor circuit SC, the pixel circuits PXC1 and PXC2 on the left side and the pixel circuits PXC3 and PXC4 on the right side may be symmetrical with each other, and may be substantially the same as each other. For convenience, FIGS. 10 to 17 focus on the second pixel circuit PXC2, the sensor circuit SC, and the third pixel circuit PXC3.

Each of the first to fourth sub-pixels SPX1 to SPX4 may include the substrate SUB and may further include the pixel circuit layer PCL, the display element layer (see "DPL" of FIG. 8), the thin-film encapsulation layer TFL, the color filter layer CFL, and the windows WD. The first light-sensing pixel PSR1 may include the substrate SUB, the pixel circuit layer PCL, the sensor layer SSL, the thin-film encapsulation layer TFL, the color filter layer CFL, and the window WD.

The substrate SUB may include a transparent insulating material to allow light to pass therethrough. The substrate SUB may be a rigid substrate or a flexible substrate.

The first to fourth pixel circuits PXC1 to PXC4, the sensor circuit SC, and the signal lines may be located in the pixel circuit layer PCL.

A light-emitting device (refer to "LED" in FIG. 8) that is electrically connected to each of the first to fourth pixel circuits (PXC1 to PXC4) may be located on the display device layer (DPL). The light-receiving element (see "LRD" of FIG. 8) electrically connected to the sensor circuit SC may be located on the sensor layer SSL.

A first insulating layer INS1, a second insulating layer INS2, a third insulating layer INS3, a fourth insulating layer INS4, a fifth insulating layer INS5, a sixth insulating layer INS6, a seventh insulating layer INS7, an eighth insulating layer INS8, and a ninth insulating layer INS9 may be sequentially stacked along the third direction DR3 from one surface of the substrate SUB. The insulating layers INS1, INS2, INS3, INS4, INS5, INS6, INS7, INS8, INS9 may be in the pixel circuit layer PCL.

At least one conductive layer and at least one semiconductor layer may be located on the pixel circuit layer PCL. For example, the pixel circuit layer PCL may include a first semiconductor layer, a first conductive layer CL1, a second conductive layer CL2, a second semiconductor layer, a third conductive layer CL3, a fourth conductive layer CL4, a fifth conductive layer CL5, and a sixth conductive layer CL6, which are sequentially stacked along the third direction DR3 from one surface of the substrate SUB.

The signal lines may be located in the display area DA where the first to fourth sub-pixels SPX1 to SPX4 and the first light-sensing pixel PSR1 are located. For example, first to nineteenth lines WL1 to WL19, second and third data lines D2 and D3, a first power line PL1, and first and second vertical bridge lines BRL1_V and BRL2_V may be located in the display area DA.

Referring to FIGS. 10 and 11, the first line WL1 may extend in the first direction DR1 and may include the first conductive layer CL1. The first line WL1 may be the 3i-th scan line S3i described with reference to FIG. 7. A portion of the first line WL1 may be the gate electrode (hereinafter referred to as the "seventh gate electrode") of the seventh transistor T7 of each of the second and third pixel circuits PXC2 and PXC3. Another portion of the first line WL1 may be the gate electrode (hereinafter referred to as the "eighth gate electrode") of the eighth transistor T8 of each of the second and third pixel circuits PXC2 and PXC3.

The second line WL2 may extend in the first direction DR1, and may be spaced from the first line WL1. The second line WL2 may include the first conductive layer CL1. The second line WL1 may be the 1i-th scan line S1i described with reference to FIG. 7. A portion of the second line WL2 may be the gate electrode (hereinafter referred to as the "second gate electrode") of the second transistor T2 of each of the second and third pixel circuits PXC2 and PXC3. Another portion of the second line WL2 may be the gate electrode (hereinafter referred to as an "11a-th gate electrode") of the 11a-th transistor T11a of the sensor circuit SC. The protrusion of the second line WL2 may be the gate electrode (hereinafter referred to as an "11b-th gate electrode") of the 11b-th transistor T11b of the sensor circuit SC.

The third line WL3 may extend in the first direction DR1, and may be spaced from the first and second lines WL1 and WL2. The third line WL3 may include the first conductive layer CL1. In one or more embodiments, the third line WL3 may be the i-th emission control line Ei described with reference to FIG. 7. A portion of the third line WL3 may be the gate electrode (hereinafter referred to as the "fifth gate electrode") of the fifth transistor T5 of each of the second and third pixel circuits PXC2 and PXC3. Another portion of the third line WL3 may be the gate electrode (hereinafter referred to as the "sixth gate electrode") of the sixth transistor T6 of each of the second and third pixel circuits PXC2 and PXC3.

Referring to FIGS. 10 and 12, the fourth line WL4 may extend in the first direction DR1, and may be part of the second conductive layer CL2. The fourth line WL4 may be a dummy line that overlaps the eighth line WL8 of the third conductive layer CL3, but the present disclosure is not limited thereto.

The fifth line WL5 may extend in the first direction DR1, and may be part of the second conductive layer CL2. The fifth line WL5 may be spaced from the fourth line WL4. The fifth line WL5 may be a dummy line that overlaps the ninth line WL9 of the third conductive layer CL3, but the present disclosure is not limited thereto.

The sixth line WL6 may extend in the first direction DR1, and may be part of the second conductive layer CL2. The sixth line WL6 may be spaced from the fourth and fifth lines WL4 and WL5. The sixth line WL6 may be a dummy line that overlaps the eleventh line (e.g., a first line in the claims) WL11 of the third conductive layer CL3, but the present disclosure is not limited thereto.

Referring to FIGS. 10 and 13, the seventh line WL7 may extend in the first direction DR1, and may be part of the third conductive layer CL3. In one or more embodiments, the seventh line WL7 may be the sixth power line PL6 described with reference to FIG. 7. The seventh line WL7 may be supplied with the common voltage (see "VCOM" of FIG. 7) (or the second initialization power supply voltage Vint2).

The eighth line WL8 may extend in the first direction DR1 and may be spaced from the seventh line WL7. The eighth line WL8 may be part of the third conductive layer CL3. The eighth line WL8 may be the 4i-th scan line S4i described with reference to FIG. 7. A portion of the eighth line WL8 may be the gate electrode (hereinafter referred to as the "third gate electrode") of the third transistor T3 of each of the second and third pixel circuits PXC2 and PXC3.

The ninth line WL9 may extend in the first direction DR1 and may be spaced from the seventh and eighth lines WL7 and WL8. The ninth line WL9 may be part of the third conductive layer CL3. The ninth line WL9 may be the 2i-th scan line S2i described with reference to FIG. 7. A portion of the ninth line WL9 may be the gate electrode (hereinafter referred to as the "fourth gate electrode") of the fourth transistor T4 of each of the second and third pixel circuits PXC2 and PXC3.

The tenth line WL10 may extend in the first direction DR1 and may be spaced from the seventh to ninth lines WL7 to WL9. The tenth line WL10 may be part of the third conductive layer CL3. The tenth line WL10 may be the sixth power line PL6 described with reference to FIG. 7. The tenth line WL10 may be supplied with a common voltage VCOM (or the second initialization power supply voltage Vint2). In one or more embodiments, the seventh line WL7 and the tenth line WL10 may be supplied with the same voltage, for example, the common voltage VCOM.

The eleventh line WL11 may extend in the first direction DR1 and may be spaced from the seventh to tenth lines WL7 to WL10. The eleventh line WL11 may be part of the third conductive layer CL3. The eleventh line WL11 may be the reset line RSTL described with reference to FIG. 7. A portion of the eleventh line WL11 may be the gate electrode (hereinafter referred to as the "tenth gate electrode") of the tenth transistor T10 of the sensor circuit SC. The tenth gate electrode may be the tenth gate electrode GE10 described with reference to FIG. 8.

Referring to FIGS. 10, 14, and 17 to 19, the twelfth line WL12 may extend in the first direction DR1, and may be part of the fourth conductive layer CL4. The twelfth line WL12 may be the fourth power line PL4 described with reference to FIG. 7. The twelfth line WL12 may be supplied with the bias voltage (see "VOBS" of FIG. 7). The twelfth line WL12 may be electrically connected to the first semiconductor pattern SCP1 of the eighth transistor T8 of each of the second and third pixel circuits PXC2 and PXC3.

The thirteenth line WL13 may extend in the first direction DR1, and may be spaced from the twelfth line WL12. The thirteenth line WL13 may be part of the fourth conductive layer CL4. The thirteenth line WL13 may be the second power line PL2 described with reference to FIG. 7. The thirteenth line WL13 may be supplied with the first initialization power supply voltage (see "Vint1" of FIG. 7). The thirteenth line WL13 may be electrically connected to the third semiconductor pattern SCP3 of the fourth transistor T4 of each of the second and third pixel circuits PXC2 and PXC3. In accordance with one or more embodiments, the thirteenth line WL13 may be electrically connected to the seventeenth line WL17 of the sixth conductive layer CL6.

The fourteenth line WL14 may extend in the first direction DR1. The fourteenth line WL14 may be spaced from the twelfth and thirteenth lines WL12 and WL13. The fourteenth line WL14 may be part of the fourth conductive layer CL4. The fourteenth line WL14 may be the horizontal bridge line BRL_H. The fourteenth line WL14 may be electrically connected to the corresponding data line among the data lines located in the first area (see "DA1" of FIG. 3) of the display area DA. The fourteenth line WL14 may overlap the fourth connection pattern CNP4 of each of the second and third sub-pixels SPX2 and SPX3. In one or more embodiments, the fourteenth line WL14 may be electrically connected to the fourth connection pattern CNP4 of each of the second and third sub-pixels SPX2 and SPX3.

The fourth connection pattern CNP4 may be part of the fifth conductive layer CL5. The fourth connection pattern CNP4 of each of the second and third sub-pixels SPX2 and SPX3 may overlap the fourteenth line WL14, and may be electrically connected to the fourteenth line WL14 through the corresponding first via hole VIH1.

The fifteenth line WL15 may extend in the first direction DR1, and may be spaced from the twelfth to fourteenth lines WL12 to WL14. The fifteenth line WL15 may be part of the fourth conductive layer CL4. The fifteenth line WL15 may be the fifth power line PL5 described with reference to FIG. 7. The fifteenth line WL15 may be supplied with the reset voltage (see "VRST" of FIG. 7). The fifteenth line WL15 may be electrically connected to the fourth semiconductor pattern SCP4 of the tenth transistor T10 of the sensor circuit SC.

Referring to FIGS. 10, 15, and 17 to 19, the sixteenth line (e.g., a second line in the claims) WL16 may extend in the second direction DR2, and may be part of the fifth conductive layer CL5. The sixteenth line WL16 may be electrically connected to the fifteenth line WL15, e.g. through the first via hole VIH1 that passes through the seventh insulating layer INS7. The sixteenth line WL16 may be located within the first light-sensing pixel PSR1 where the sensor circuit SC is located, but the present disclosure is not limited thereto. In one or more embodiments, the sixteenth line WL16 may include a first sub-line WL16a extending in the first direction DR1 and a second sub-line WL16b extending in the second direction DR2 and located adjacent to the third pixel circuit PXC3. The sixteenth line WL16 may include a third sub-line WL16c extending in the second direction DR2 and located adjacent to the second pixel circuit PXC2. In a plan view, the first and second sub-lines WL16a and WL16b may overlap the nineteenth line WL19 (or the readout line).The third sub-line WL16c may not overlap the nineteenth line 19. In a plan view, the first sub-line WL16a may overlap the fifteenth line WL15 of the fourth conductive layer CL4.

Referring to FIGS. 10 and 15 to 17, the seventh line WL17 may extend in the second direction DR2, and may be part of the sixth conductive layer CL6. The seventeenth line WL17 may be located between the first sub-pixel SPX1 and the second sub-pixel SPX2. The seventeenth line WL17 may be the third power line PL3 described with reference to FIG. 7 in each of the first and second sub-pixels SPX1 and SPX2. The seventeenth line WL17 may be supplied with the second initialization power supply voltage Vint2. The seventeenth line WL17 may be electrically connected to the first connection pattern CNP1 of each of the first and second sub-pixels SPX1 and SPX2 through the second via hole VIH2 that passes through the eighth insulating layer INS8.

The first connection pattern CNP1 of each of the first and second sub-pixels SPX1 and SPX2 may be part of the fifth conductive layer CL5. The first connection pattern CNP1 may be electrically connected to the seventeenth line WL17 through the corresponding second via hole VIH2. The first connection pattern CNP1 may be electrically connected to the seventh conductive pattern CP7 of the first sub-pixel SPX1 through the first via hole VIH1 that passes through the seventh insulating layer INS7. In accordance with one or more embodiments, the first connection pattern CNP1 may be electrically connected to the seventh conductive pattern CP7 of the second sub-pixel SPX2.

The seventh conductive pattern CP7 may be part of the fourth conductive layer CL4. The seventh conductive pattern CP7 may be electrically connected to the first connection pattern CNP1 through the corresponding first via hole VIH1.

The eighteenth line WL18 may extend in the second direction DR2, and may be spaced from the seventeenth line WL17. The eighteenth line WL18 may be part of the sixth conductive layer CL6. The eighteenth line WL18 may be located between the third sub-pixel SPX3 and the fourth sub-pixel SPX4. The eighteenth line WL18 may be electrically connected to the first connection pattern CNP1 of each of the third and fourth sub-pixels SPX3 and SPX4 through the second via hole VIH2 that passes through the eighth insulating layer INS8.

The first connection pattern CNP1 of each of the third and fourth sub-pixels SPX3 and SPX4 may be part of the fifth conductive layer CL5. The first connection pattern CNP1 may be electrically connected to the eighteenth line WL18 through the corresponding second via hole VIH2. The first connection pattern CNP1 may be electrically connected to the seventh conductive pattern CP7 of the third sub-pixel SPX3 through the first via hole VIH1 that passes through the seventh insulating layer INS7. In accordance with one or more embodiments, the first connection pattern CNP1 may be electrically connected to the seventh conductive pattern CP7 of the fourth sub-pixel SPX4.

The nineteenth line WL19 may extend in the second direction DR2. The nineteenth line WL19 may be spaced from the seventeenth and eighteenth lines WL17 and WL18. The nineteenth line WL19 may be part of the sixth conductive layer CL6. The nineteenth line WL19 may be the k-th readout line RXk (hereinafter referred to as the "readout line") described with reference to FIG. 7. The nineteenth line WL19 may be electrically connected to the sixth connection pattern CNP6 through the second via hole VIH2 that passes through the eighth insulating layer INS8.

The sixth connection pattern CNP6 may be part of the fifth conductive layer CL5. The sixth connection pattern CNP6 may be located on the first light-sensing pixel PSR1 and may be electrically connected to the nineteenth line WL19 through the corresponding second via hole VIH2. The sixth connection pattern CNP6 may be electrically connected to an eighth conductive pattern CP8 through the first via hole VIH1 that passes through the seventh insulating layer INS7.

The eighth conductive pattern CP8 may be part of the fourth conductive layer CL4. The eighth connection pattern CP8 may be located on the first light-sensing pixel PSR1, and may be electrically connected to the sixth connection pattern CNT6 through the corresponding first via hole VIH1. The eighth conductive pattern CP8 may be electrically connected to the second semiconductor pattern SCP2 of the 11b-th transistor T11b through the first contact portion CNT1 that passes through the sixth insulating layer INS6, the fifth insulating layer INS5, the fourth insulating layer INS4, the third insulating layer INS3, and the second insulating layer INS2.

The nineteenth line WL19 may be electrically connected to the second semiconductor pattern SCP2 of the 11b-th transistor T11b through the sixth connection pattern CNP6 and the eighth conductive pattern CP8.

In one or more embodiments, the fifteenth line WL15 may be the horizontal power line of the fifth power line PL5, and the sixteenth line WL16 may be the vertical power line of the fifth power line PL5. The fifteenth line WL15 that extends in the first direction DR1 and includes the fourth conductive layer CL4 and the sixteenth line WL16 that extends in the second direction DR2, and includes the fifth conductive layer CL5 may be electrically connected to each other so that the fifth power line PL5 is formed in a mesh structure. That is, the fifth power line PL5 may have a mesh structure due to the fifteenth line WL15 and the sixteenth line WL16 electrically connected to each other.

The second data line D2 may extend in the second direction DR2. The second data line D2 may be part of the sixth conductive layer CL6. The second data line D2 may be located on the same layer as the seventeenth to nineteenth lines WL17 to WL 19, and may be spaced from the seventeenth to nineteenth lines WL17 to WL19. The second data line D2 may be the j-th data line Dj described with reference to FIG. 7. The second data line D2 may be electrically connected to the first semiconductor pattern SCP1 of the second transistor T2 of the second pixel circuit PXC2.

The third data line D3 may extend in the second direction DR2. The third data line D3 may be part of the sixth conductive layer CL6. The third data line D3 may be located on the same layer as the second data line D2, and is spaced from the second data line D2. The third data line D3 may be the j-th data line Dj described with reference to FIG. 7. The third data line D3 may be electrically connected to the first semiconductor pattern SCP1 of the second transistor T2 of the third pixel circuit PXC3.

The first vertical bridge line BRL1_V may extend in the second direction DR2. The first vertical bridge line BRL1_V may be part of the sixth conductive layer CL6. The first vertical bridge line BRL1_V may be located on the same layer as the second and third data lines D2 and D3, and may be spaced from the second and third data lines D2 and D3. The first vertical bridge line BRL1_V may overlap a portion of the second pixel circuit PXC2 within the second sub-pixel SPX2. The first vertical bridge line BRL1_V may be electrically connected to the corresponding data line among the data lines located in the first area(s) DA1. The first vertical bridge line BRL1_V may electrically connect the data line to the fan-out line located in the fan-out area (the "FTA" area of FIG. 3) of the non-display area (see "NDA" of FIG. 3). The first vertical bridge line BRL1_V may be electrically connected to the fourth connection pattern CNP4 of the second sub-pixel SPX2 through the second via hole VIH2 that passes through the eighth insulating layer INS8.

The second vertical bridge line BRL2_V may extend in the second direction DR2. The second vertical bridge line BRL2_V may be spaced from the first vertical bridge line BRL1_V. The second vertical bridge line BRL2_V may be part of the sixth conductive layer CL6. The second vertical bridge line BRL2_V may overlap a portion of the third pixel circuit PXC3 within the third sub-pixel SPX3. The second vertical bridge line BRL2_V may be electrically connected to the corresponding data line among the data lines located in the first area(s) DA1. The second vertical bridge line BRL2_V may electrically connect the data line to the corresponding fan-out line located in the fan-out area FTA. The second vertical bridge line BRL2_V may be electrically connected to the fourth connection pattern CNP4 of the third sub-pixel SPX3 through the second via hole VIH2 that passes through the eighth insulating layer INS8.

The first power line PL1 may extend in the second direction DR2, and may be part of the fifth conductive layer CL5. The first power line PL1 may be the first power line PL1 described with reference to FIG. 7. The first power line PL1 may be supplied with the first power supply voltage VDD. The first power supply voltage VDD may be a DC voltage having a constant voltage level. The first sub-pixel SPX1 and the second sub-pixel SPX2 may share one first power line PL1 with each other, and the third sub-pixel SPX3 and the fourth sub-pixel SPX4 may share one first power line PL1 with each other.

In each of the second and third sub-pixels SPX2 and SPX3, the first power line PL1 may be electrically connected to the first conductive pattern CP1 of the fourth conductive layer CL4 through the first via hole VIH1 that passes through the seventh insulating layer INS7.

The first conductive pattern CP1 may be part of the fourth conductive layer CL4, and may be electrically connected to the first power line PL1 through the corresponding first via hole VIH1. The first conductive pattern CP1 may be electrically connected to the first semiconductor pattern SCP1 of the fifth transistor T5 of each of the second and third pixel circuits PXC2 and PXC3 through the corresponding first contact portion CNT1 that passes through the sixth insulating layer INS6, the fifth insulating layer INS5, the fourth insulating layer INS4, the third insulating layer INS3, and the second insulating layer INS2. The first conductive pattern CP1 may be electrically connected to the upper electrode UE of the second conductive layer CL2 through the corresponding first contact portion CNT1 that passes through the sixth insulating layer INS6, the fifth insulating layer INS5, and the fourth insulating layer INS4.

The first pixel circuit PXC1, the second pixel circuit PXC2, the third pixel circuit PXC3, and the fourth pixel circuit PXC4 may have structures that are substantially similar to or identical to each other. For example, the first and second pixel circuits PXC1 and PXC2 located on the left side of the sensor circuit SC and the third and fourth pixel circuits PXC3 and PXC4 located on the right side of the sensor circuit SC may be mutually symmetrical with each other. That is, the first pixel circuit PXC1 and the third pixel circuit PXC3 may be mutually symmetrical with each other, and the second pixel circuit PXC2 and the fourth pixel circuit PXC4 may be mutually symmetrical with each other. In one or more embodiments, the first pixel circuit PXC1 and the second pixel circuit PXC2 may have mirror symmetry, and the third pixel circuit PXC3 and the fourth pixel circuit PXC4 may have mirror symmetry, but the present disclosure is not limited thereto.

Hereinafter, for convenience, the description will focus on the second pixel circuit PXC2 and redundant descriptions will not be repeated.

The second pixel circuit PXC2 may include first, second, third, fourth, fifth, sixth, seventh, and eighth transistors T1, T2, T3, T4, T5, T6, T7, and T8 and a storage capacitor Cst.

The first transistor T1 may include a first active pattern ACT1 and a first gate electrode GE1.

The first active pattern ACT1 may be a region of the first semiconductor pattern SCP1 that overlaps the first gate electrode GE1. The first semiconductor pattern SCP1 may be a first semiconductor layer. The first active pattern ACT1 may be a channel region of the first transistor T1.

For example, the channel region is a semiconductor pattern that is not doped with impurities and may be an intrinsic semiconductor. The remaining region of the semiconductor pattern excluding the channel region may be a semiconductor pattern doped with impurities.

One region of the first semiconductor pattern SCP1 that does not overlap the first gate electrode GE1 and that is connected to one side of the first active pattern ACT1 (or the channel region, e.g., the right side of the first active pattern ACT1 in a plan view) may be a first contact region. One region of the first semiconductor pattern SCP1 that does not overlap the first gate electrode GE1 and that is connected to the other side of the first active pattern ACT1 (e.g., the left side of the first active pattern ACT1 in a plan view) may be a second contact region. The first contact region and the second contact region may extend in opposite directions from the first active pattern ACT1. The first contact region may be connected to one side of the first active pattern ACT1, and may be connected to the first semiconductor pattern SCP1 of the second transistor T2 and the first semiconductor pattern SCP1 of the fifth transistor T5. The second contact region may be connected to the other side of the first active pattern ACT1 and may be connected to the first semiconductor pattern SCP1 of the sixth transistor T6.

The first gate electrode GE1 may overlap the first active pattern ACT1, and may include the first conductive layer CL1. The first gate electrode GE1 may be an island-shaped conductive pattern. The first gate electrode GE1 may be electrically connected to the third transistor T3 and the fourth transistor T4 through the third conductive pattern CP3.

The third conductive pattern CP3 may be part of the fourth conductive layer CL4. One end of the third conductive pattern CP3 may be electrically connected to the first gate electrode GE1 through the corresponding first contact portion CNT1 that passes through the sixth insulating layer INS6, the fifth insulating layer INS5, the fourth insulating layer INS4, and the third insulating layer INS3. The other end of the third conductive pattern CP3 may be electrically connected to one region of the third semiconductor pattern SCP3 shared by the third transistor T3 and the fourth transistor T4 through the second contact portion CNT2 that passes through the sixth insulating layer INS6 and the fifth insulating layer INS5.

The second transistor T2 may include a second active pattern ACT2 and a second gate electrode.

The second active pattern ACT2 may be one region of the first semiconductor pattern SCP1 that overlaps the second line WL2. The first semiconductor pattern SCP1 may include the first semiconductor layer. The second active pattern ACT2 may be a channel region of the second transistor T2.

One region of the first semiconductor pattern SCP1 that does not overlap the second line WL2 and that is connected to one side of the second active pattern ACT2 (e.g., the lower side of the second active pattern ACT2 in a plan view) may be a first contact region, and one region of the first semiconductor pattern SCP1 that does not overlap the second line WL2 and that is connected to the other side of the second active pattern ACT2 (e.g., the upper side of the second active pattern ACT2 in a plan view) may be a second contact region. The first contact region may be connected to one side of the second active pattern ACT2, and may be electrically connected to the sixth conductive pattern CP6. The second contact region may be connected to the other side of the second active pattern ACT2, and may be connected to the first contact region of the first transistor T1.

The sixth conductive pattern CP6 may be part of the fourth conductive layer CL4. The sixth conductive pattern CP6 may be electrically connected to the first semiconductor pattern SCP1 corresponding to the first contact region of the second transistor T2 through the first contact portion CNT1 that passes through the sixth insulating layer INS6, the fifth insulating layer INS5, the fourth insulating layer INS4, the third insulating layer INS3, and the second insulating layer INS2. The sixth conductive pattern CP6 may be electrically connected to the third connection pattern CNP3 through the first via hole VIH1.

The third connection pattern CNP3 may be part of the fifth conductive layer CL5, and may be electrically connected to the sixth conductive pattern CP6 through the first via hole VIH1 that passes through the seventh insulating layer INS7. The third connection pattern CNP3 may be electrically connected to the second data line D2 of the sixth conductive layer CL6 through the second via hole VIH2 that passes through the eighth insulating layer INS8.

One region of the first semiconductor pattern SCP1 of the second transistor T2 may be electrically connected to the second data line D2 through the sixth conductive pattern CP6 and the third connection pattern CNP3.

The second gate electrode may be one region of the second line WL2 that overlaps the second active pattern ACT2.

The third transistor T3 may include a third active pattern ACT3 and a third gate electrode.

The third active pattern ACT3 is one region of the third semiconductor pattern SCP3 that overlaps the eighth line WL8, and may form a channel region of the third transistor T3. The third semiconductor pattern SCP3 may include the second semiconductor layer.

One region of the third semiconductor pattern SCP3 that does not overlap the eighth line WL8 and that is connected to one side of the third active pattern ACT3 (e.g., the upper side of the third active pattern ACT3 in a plan view) may be a first contact region, and one region of the third semiconductor pattern SCP3 that does not overlap the eighth line WL8 and that is connected to the other side of the third active pattern ACT3 (e.g., the lower side of the third active pattern ACT3 in a plan view) may be a second contact region. The first contact region may be connected to one side of the third active pattern ACT3, and may be electrically connected to the first transistor T1 and the sixth transistor T6 through the fifth conductive pattern CP5. The second contact region may be connected to the other side of the third active pattern ACT3, and may be connected to the third semiconductor pattern SCP3 of the fourth transistor T4.

The fifth conductive pattern CP5 may be part of the fourth conductive layer CL4. One end of the fifth conductive pattern CP5 may be electrically connected to the first contact region of the third transistor T3 through the second contact portion CNT2 that passes through the sixth insulating layer INS6 and the fifth insulating layer INS5. The fifth conductive pattern CP5 may be electrically connected to one region of the first semiconductor pattern SCP1 shared by the first transistor T1 and the sixth transistor T6 through the first contact portion CNT1 that passes through the sixth insulating layer INS6, the fifth insulating layer INS5, the fourth insulating layer INS4, the third insulating layer INS3, and the second insulating layer INS2.

The third gate electrode may be one region of the eighth line WL8 that overlaps the third active pattern ACT3.

The fourth transistor T4 may include a fourth active pattern ACT4 and a fourth gate electrode.

The fourth active pattern ACT4 is one region of the third semiconductor pattern SCP3 that overlaps the ninth line WL9, and may form a channel region of the fourth transistor T4. The third semiconductor pattern SCP3 may include the second semiconductor layer.

One region of the third semiconductor pattern SCP3 that does not overlap the ninth line WL9 and that is connected to one side of the fourth active pattern ACT4 (e.g., the upper side of the fourth active pattern ACT4 in a plan view) may be a first contact region, and one region of the third semiconductor pattern SCP3 that does not overlap the ninth line WL9 and that is connected to the other side of the fourth active pattern ACT4 (e.g., the lower side of the fourth active pattern ACT4 in a plan view) may be a second contact region. The first contact region may be connected to one side of the fourth active pattern ACT4, and may be connected to the third semiconductor pattern SCP3 of the third transistor T3. The second contact region may be connected to the other side of the fourth active pattern ACT4, and may be electrically connected to the thirteenth line WL13 of the fourth conductive layer CL4 through the corresponding second contact portion CNT2 that passes through the sixth insulating layer INS6 and the fifth insulating layer INS5.

The fourth gate electrode may be one region of the ninth line WL9 that overlaps the fourth active pattern ACT4.

The fifth transistor T5 may include a fifth active pattern ACT5 and a fifth gate electrode.

The fifth active pattern ACT5 is one region of the first semiconductor pattern SCP1 that overlaps the third line WL3, and may form a channel region of the fifth transistor T5. The first semiconductor pattern SCP1 may include the first semiconductor layer.

One region of the first semiconductor pattern SCP1 that does not overlap the third line WL3 and that is connected to one side of the fifth active pattern ACT5 (e.g., the upper side of the fifth active pattern ACT5 in a plan view) may be a first contact region, and one region of the first semiconductor pattern SCP1 that does not overlap the third line WL3 and that is connected to the other side of the fifth active pattern ACT5 (e.g., the lower side of the fifth active pattern ACT5 in a plan view) may be a second contact region. The first contact region may be connected to one side of the fifth active pattern ACT5 and may be electrically connected to the first conductive pattern CP1 through the corresponding first contact portion CNT1. The second contact region may be connected to the other side of the fifth active pattern ACT5 and may be connected to the first semiconductor pattern SCP1 of each of the first and second transistors T1 and T2.

The fifth gate electrode may be one region of the third line WL3 that overlaps the fifth active pattern ACT5.

The sixth transistor T6 may include a sixth active pattern ACT6 and a sixth gate electrode.

The sixth active pattern ACT6 is one region of the first semiconductor pattern SCP1 that overlaps the third line WL3, and may be a channel region of the sixth transistor T6. The first semiconductor pattern SCP1 may include the first semiconductor layer.

One region of the first semiconductor pattern SCP1 that does not overlap the third line WL3 and that is connected to one side of the sixth active pattern ACT6 (e.g., the upper side of the sixth active pattern ACT6 in a plan view) may be a first contact region, and one region of the first semiconductor pattern SCP1 that does not overlap the third line WL3 and that is connected to the other side of the sixth active pattern ACT6 (e.g., the lower side of the sixth active pattern ACT6 in a plan view) may be a second contact region. The first contact region may be connected to one side of the sixth active pattern ACT6 and the first semiconductor pattern SCP1 of the seventh transistor T7. The second contact region may be connected to the other side of the sixth active pattern ACT6 and the first semiconductor pattern SCP1 of the first transistor T1. The second contact region may be electrically connected to the fifth conductive pattern CP5 through the corresponding first contact portion CNT1.

The sixth gate electrode may be one region of the third line WL3 that overlaps the sixth active pattern ACT6.

The seventh transistor T7 may include a seventh active pattern ACT7 and a seventh gate electrode.

The seventh active pattern ACT7 may be one region of the first semiconductor pattern SCP1 that overlaps the first line WL1. The first semiconductor pattern SCP1 may include the first semiconductor layer. The seventh active pattern ACT7 may be a channel region of the seventh transistor T7.

One region of the first semiconductor pattern SCP1 that does not overlap the first line WL1 and that is connected to one side of the seventh active pattern ACT7 (e.g., the lower side of the seventh active pattern ACT7 in a plan view) may be a first contact region, and one region of the first semiconductor pattern SCP1 that does not overlap the first line WL1 and that is connected to the other side of the seventh active pattern ACT7 (e.g., the upper side of the seventh active pattern ACT7 in a plan view) may be a second contact region. The first contact region may be connected to one side of the seventh active pattern ACT7, may be connected to the first semiconductor pattern SCP1 of the sixth transistor T6, and may be electrically connected to the fourth conductive pattern CP4. The second contact region may be connected to the other side of the seventh active pattern ACT7 and may be electrically connected to the seventh conductive pattern CP7.

The fourth conductive pattern CP4 may be part of the fourth conductive layer CL4. The fourth conductive pattern CP4 may be electrically connected to the first semiconductor pattern SCP1 of the seventh transistor T7 through the corresponding first contact portion CNT1 that passes through the sixth insulating layer INS6, the fifth insulating layer INS5, the fourth insulating layer INS4, the third insulating layer INS3, and the second insulating layer INS2. The fourth conductive pattern CP4 may be electrically connected to the second connection pattern CNP2.

The second connection pattern CNP2 may be part of the fifth conductive layer CL5. One end of the second connection pattern CNP2 may be electrically connected to the fourth conductive pattern CP4 through the corresponding first via hole VIH1 that passes through the seventh insulating layer INS7. The other end of the second connection pattern CNP2 may be electrically connected to the first bridge pattern BRP1 of the sixth conductive layer CL6 through the corresponding second via hole VIH2.

The first bridge pattern BRP1 may be part of the sixth conductive layer CL6. The first bridge pattern BRP1 may be electrically connected to the second connection pattern CNP2 through the corresponding second via hole VIH2 that passes through the eighth insulating layer INS8. The first bridge pattern BRP1 may be electrically connected to the first semiconductor pattern SCP1 of the seventh transistor T7 and the first semiconductor pattern SCP1 of the sixth transistor T6 through the second connection pattern CNP2 and the fourth conductive pattern CP4. In one or more embodiments, the first bridge pattern BRP1 may be electrically connected to the anode electrode (see "AE" of FIG. 8) of the light-emitting element (see "LED" of FIG. 8) through the third via hole (see "VIH3" of FIG. 8) that passes through the ninth insulating layer INS9.

The seventh conductive pattern CP7 may be part of the fourth conductive layer CL4. The seventh conductive pattern CP7 may be electrically connected to the first semiconductor pattern SCP1 of the seventh transistor T7 through the first contact portion CNT1 that passes through the sixth insulating layer INS6, the fifth insulating layer INS5, the fourth insulating layer INS4, the third insulating layer INS3, and the second insulating layer INS2. The seventh conductive pattern CP7 may be electrically connected to the seventh line WL7 through the second contact portion CNT2 that passes through the sixth insulating layer INS6, the fifth insulating layer INS5, and the fourth insulating layer INS4.

The seventh gate electrode may be one region of the first line WL1 that overlaps the seventh active pattern ACT7.

The eighth transistor T8 may include an eighth active pattern ACT8 and an eighth gate electrode.

The eighth active pattern ACT8 may be one region of the first semiconductor pattern SCP1 that overlaps the first line WL1. The first semiconductor pattern SCP1 may include the first semiconductor layer. The eighth active pattern ACT8 may be a channel region of the eighth transistor T8.

One region of the first semiconductor pattern SCP1 that does not overlap the first line WL1 and that is connected to one side of the eighth active pattern ACT8 (e.g., the upper side of the eighth active pattern ACT8 in a plan view) may be a first contact region, and one region of the first semiconductor pattern SCP1 that does not overlap the first line WL1 and that is connected to the other side of the eighth active pattern ACT8 (e.g., the lower side of the eighth active pattern ACT8 in a plan view) may be a second contact region. The first contact region may be connected to one side of the eighth active pattern ACT8, and may be electrically connected to the twelfth line WL12. The second contact region may be connected to the other side of the eighth active pattern ACT8, and may be electrically connected to the second conductive pattern CP2.

The twelfth line WL12 of the fourth conductive layer CL4 may be electrically connected to the first contact region of the first semiconductor pattern SCP1 of the eighth transistor T8 through the first contact portion CNT1 that passes through the sixth insulating layer INS6, the fifth insulating layer INS5, the fourth insulating layer INS4, the third insulating layer INS3, and the second insulating layer INS2.

The second conductive pattern CP2 of the fourth conductive layer CL4 may be electrically connected to the second contact region of the first semiconductor pattern SCP1 of the eighth transistor T8 through the first contact portion CNT1 that passes through the sixth insulating layer INS6, the fifth insulating layer INS5, the fourth insulating layer INS4, the third insulating layer INS3, and the second insulating layer INS2. The second conductive pattern CP2 may be electrically connected to the first semiconductor pattern SCP1 of the fifth transistor T5 through the first contact portion CNT1 that passes through the sixth insulating layer INS6, the fifth insulating layer INS5, the fourth insulating layer INS4, the third insulating layer INS3, and the second insulating layer INS2.

The eighth gate electrode may be one region of the first line WL1 that overlaps the eighth active pattern ACT8.

The storage capacitor Cst may include a lower electrode LE and an upper electrode UE.

The lower electrode LE may be integrally formed with the first gate electrode GE1. The lower electrode LE may include the first conductive layer CL1.

The upper electrode UE may overlap the lower electrode LE, and may be part of the second conductive layer CL2. The upper electrode UE may include an opening OPN with a portion thereof removed. One region of the lower electrode LE that overlaps the upper electrode UE may be exposed by the opening OPN. The upper electrode UE may be electrically connected to the first conductive pattern CP1.

The sensor circuit SC may be located between the second pixel circuit PXC2 and the third pixel circuit PXC3. However, the present disclosure is not limited thereto and the position of the sensor circuit SC may be variously changed.

The sensor circuit SC may include the ninth transistor T9, the tenth transistor T10, and the eleventh transistor T11.

The ninth transistor T9 may include the ninth active pattern ACT9 and the ninth gate electrode GE9.

The ninth active pattern ACT9 may be one region of the second semiconductor pattern SCP2 that overlaps the ninth gate electrode GE9. The second semiconductor pattern SCP2 may include the first semiconductor layer. The second semiconductor pattern SCP2 may be spaced from the first semiconductor pattern SCP1. The ninth active pattern ACT9 may be a channel region of the ninth transistor T9.

One region of the second semiconductor pattern SCP2 that does not overlap the ninth gate electrode GE9 and that is connected to the other side of the ninth active pattern ACT9 (e.g., the left side of the ninth active pattern ACT9 in a plan view) may be a first contact region. One region of the second semiconductor pattern SCP2 that does not overlap the ninth gate electrode GE9 and that is connected to the other side of the ninth active pattern ACT9 (e.g., the right side of the ninth active pattern ACT9 in a plan view) may be a second contact region. The first contact region may be connected to one side of the ninth active pattern ACT9, and may be electrically connected to the ninth conductive pattern CP9. The second contact region may be connected to one side of the ninth active pattern ACT9 and the second semiconductor pattern SCP2 of the eleventh transistor T11.

The ninth conductive pattern CP9 may be located within the first light-sensing pixel PSR1, and may be part of the fourth conductive layer CL4. The ninth conductive pattern CP9 may be electrically connected to the first contact region of the ninth transistor T9 through the first contact portion CNT1 that passes through the sixth insulating layer INS6, the fifth insulating layer INS5, the fourth insulating layer INS4, the third insulating layer INS3, and the second insulating layer INS2. The ninth conductive pattern CP9 may be electrically connected to the seventh line WL7 through the second contact portion CNT2 that passes through the sixth insulating layer INS6.

The ninth gate electrode GE9 may overlap the ninth active pattern ACT9 and may include the first conductive layer CL1. The ninth gate electrode GE9 may be an island-shaped conductive pattern. The ninth gate electrode GE9 may be electrically connected to the tenth transistor T10 through the tenth conductive pattern CP10.

The tenth conductive pattern CP10 may be part of the fourth conductive layer CL4. One end of the tenth conductive pattern CP10 may be electrically connected to the ninth gate electrode GE9 through the first contact portion CNT1 that passes through the sixth insulating layer INS6, the fifth insulating layer INS5, the fourth insulating layer INS4, the third insulating layer INS3, and the second insulating layer INS2. The other end of the tenth conductive pattern CP10 may be electrically connected to the fourth semiconductor pattern SCP4 of the tenth transistor T10 through the second contact portion CNT2 that passes through the sixth insulating layer INS6 and the fifth insulating layer INS5. The tenth conductive pattern CP10 may be electrically connected to the fifth connection pattern CNP5 through the first via hole VIH1.

The fifth connection pattern CNP5 may be part of the fifth conductive layer CL5. The fifth connection pattern CNP5 may be electrically connected to the tenth conductive pattern CP10 through the corresponding first via hole VIH1 that passes through the seventh insulating layer INS7. The fifth connection pattern CNP5 may be electrically connected to the second bridge pattern BRP2 through the second via hole VIH2.

The second bridge pattern BRP2 may be part of the sixth conductive layer CL6. The second bridge pattern BRP2 may be electrically connected to the fifth connection pattern CNP5 through the corresponding second via hole VIH2 that passes through the eighth insulating layer INS8. The second bridge pattern BRP2 may be electrically connected to the ninth gate electrode GE9 of the ninth transistor T9 and the fourth semiconductor pattern SCP4 of the tenth transistor T10 through the fifth connection pattern CNP5 and the tenth conductive pattern CP10.

The second bridge pattern BRP2 may be electrically connected to the first electrode (see "EL1" of FIG. 8) of the light-receiving element (see "LRD" of FIG. 8) of the sensor circuit SC. The second bridge pattern BRP2 may be formed through the same process as the first bridge pattern BRP1, may include the same material as the first bridge pattern BRP1, and may be provided on the same layer as the first bridge pattern BRP1.

The tenth transistor T10 may include a tenth active pattern ACT10 and a tenth gate electrode.

The tenth active pattern ACT10 may be one region of the fourth semiconductor pattern SCP4 that overlaps the eleventh line WL11. The fourth semiconductor pattern SCP4 may include the second semiconductor layer. The fourth semiconductor pattern SCP4 may be spaced from the third semiconductor pattern SCP3. The tenth active pattern ACT10 may be a channel region of the tenth transistor T10.

One region of the fourth semiconductor pattern SCP4 that does not overlap the eleventh line WL11 and that is connected to one side of the tenth active pattern ACT10 (e.g., the upper side of the tenth active pattern ACT10 in a plan view) may be a first contact region. One region of the fourth semiconductor pattern SCP4 that does not overlap the eleventh line WL11 and that is connected to the other side of the tenth active pattern ACT10 (e.g., the lower side of the tenth active pattern ACT10 in a plan view) may be a second contact region. The first contact region may be connected to one side of the tenth active pattern ACT10, and may be electrically connected to the fifteenth line WL15 through the second contact portion CNT2 that passes through the sixth insulating layer INS6 and the fifth insulating layer INS5. The second contact region may be connected to the other side of the tenth active pattern ACT10, and may be electrically connected to the ninth gate electrode GE9 of the ninth transistor T9 through the tenth conductive pattern CP10.

The tenth gate electrode may be one region of the eleventh line WL11 that overlaps the tenth active pattern ACT10.

The eleventh transistor T11 may have a dual-gate structure in which sub-transistors are connected in series so as to reduce or prevent leakage current. For example, the eleventh transistor T11 may include an 11a-th transistor T11a and an 11b-th transistor T11b.

The 11a-th transistor T11a may include an 11a-th active pattern ACT11a and an 11a-th gate electrode.

The 11a-th active pattern ACT11a may be one region of the second semiconductor pattern SCP2 that overlaps the second line WL2. The second semiconductor pattern SCP2 may include the first semiconductor layer. The 11a-th active pattern ACT11a may be a channel region of the 11a-th transistor T11a.

One region of the second semiconductor pattern SCP2 that does not overlap the second line WL2 and that is connected to one side of the 11a-th active pattern ACT11a (e.g., the upper side of the 11a-th active pattern ACT11a in a plan view) may be a first contact region. One region of the second semiconductor pattern SCP2 that does not overlap the second line WL2 and that is connected to the other side of the 11a-th active pattern ACT11a (e.g., the lower side of the 11a-th active pattern ACT11a in a plan view) may be a second contact region. The first contact region may be connected to one side of the 11a-th active pattern ACT11a and the second semiconductor pattern SCP2 of the ninth transistor T9. The second contact region may be connected to the other side of the 11a-th active pattern ACT11a and the second semiconductor pattern SCP2 of the 11b-th transistor T11b.

The 11a-th gate electrode may be one region of the second line WL2 that overlaps the 11a-th active pattern ACT11a.

The 11b-th transistor T11b may include an 11b-th active pattern ACT11b and an 11b-th gate electrode.

The 11b-th active pattern ACT11b may be one region of the second semiconductor pattern SCP2 that overlaps a protrusion protruding in the second direction DR2 from the second line WL2 extending along the first direction DR1. The second semiconductor pattern SCP2 may include the first semiconductor layer. The 11b-th active pattern ACT11b may be a channel region of the 11b-th transistor T11b.

One region of the second semiconductor pattern SCP2 that does not overlap the second line WL2 and that is connected to one side of the 11b-th active pattern ACT11b (e.g., the right side of the 11b-th active pattern ACT11b in a plan view) may be a first contact region. One region of the second semiconductor pattern SCP2 that does not overlap the second line WL2 and that is connected to the other side of the 11b-th active pattern ACT11b (e.g., the left side of the 11b-th active pattern ACT11b in a plan view) may be a second contact region. The first contact region may be connected to the 11b-th active pattern ACT11b and the second semiconductor pattern SCP2 of the 11a-th transistor T11a. The second contact region may be connected to the 11b-th active pattern ACT11b, and may be electrically connected to the sixth connection pattern CNP6 through the eighth conductive pattern CP8. The second contact region may be electrically connected to the nineteenth line WL19 (or readout line) of the sixth conductive layer CL6 through the eighth conductive pattern CP8 of the fourth conductive layer CL4 and the sixth connection pattern CNP6 of the fifth conductive layer CL5.

In one or more embodiments (see e.g. FIG. 19), the nineteenth wire WL19 (or readout line) may overlap the fourteenth line WL14 corresponding to the horizontal bridge line BRL_H. The nineteenth line WL19 (or readout line) may be part of the sixth conductive layer CL6. The fourteenth line WL14 (or horizontal bridge line BRL_H) may be part of the fourth conductive layer CL6. The sixteenth line WL16 (e.g. in the fifth conductive layer CL5) may be located in an overlap area OVA where the nineteenth line WL19 and the fourteenth line WL14 overlap each other. The sixteenth line WL16 may correspond to the fifth power line PL5, and may be supplied with the reset voltage ("VRST" of FIG. 7) having a constant voltage level. A first sub-line WL16a of the sixteenth line WL16 may be located in the overlap area OVA. In the overlap area OVA, one region (e.g., the first sub-line WL16a) of the sixteenth line WL16 is located between the nineteenth line WL19 (or readout line) and the fourteenth line WL14 (or horizontal bridge line BRL_H), thereby reducing or preventing a coupling capacitance that may occur between the nineteenth line WL19 and the fourteenth line WL14. That is, the first sub-line WL16a of the sixteenth line WL16 may be used as a shielding member that reduces or prevents a coupling capacitance occurring between the nineteenth line WL19 (or readout line) and the fourteenth line WL14 (or horizontal bridge line BRL_H).

In case that the first sub-line WL16a of the sixteenth line WL16 is used as a shielding member, it is possible to reduce or prevent a phenomenon in which a signal (e.g., a data signal) applied to the fourteenth line WL14 is affected by a sensing signal transmitted to the nineteenth line WL19. Accordingly, noise generated in the sensing signal applied to the nineteenth line WL19 by the signal applied to the fourteenth line WL14 may be reduced. Accordingly, the fingerprint sensitivity and fingerprint sensing accuracy in the first light-sensing pixel PSR1 may be improved, thereby further improving the reliability of the display device (see "DD" of FIG. 1).

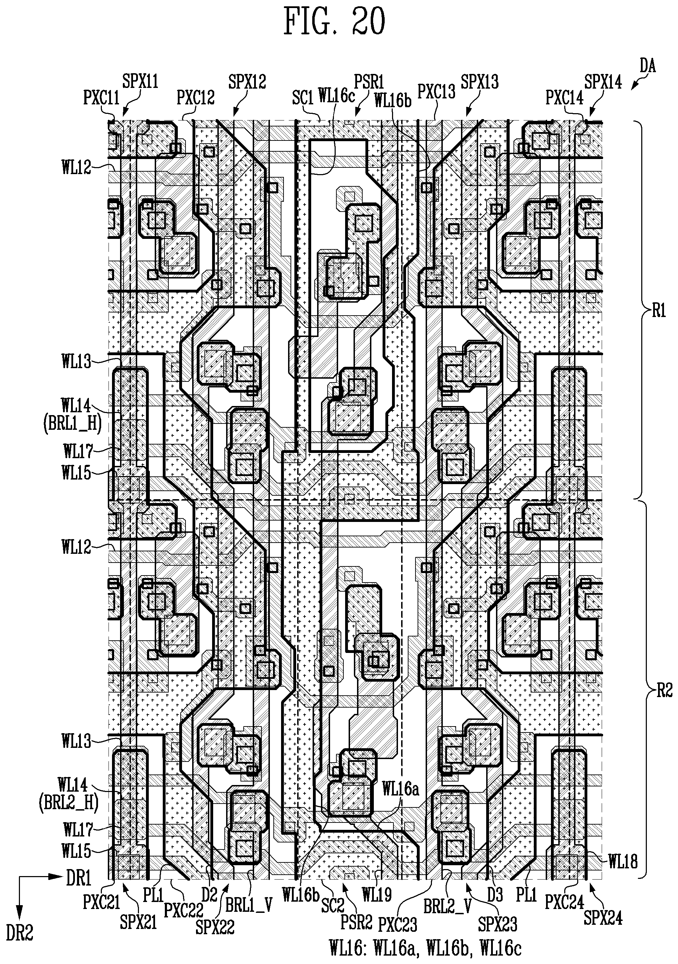

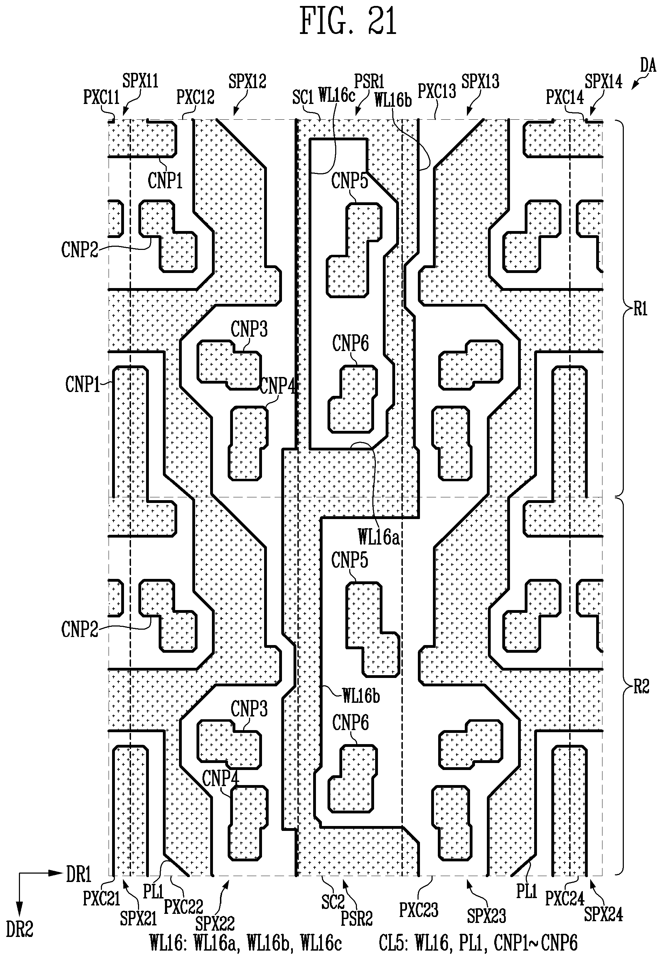

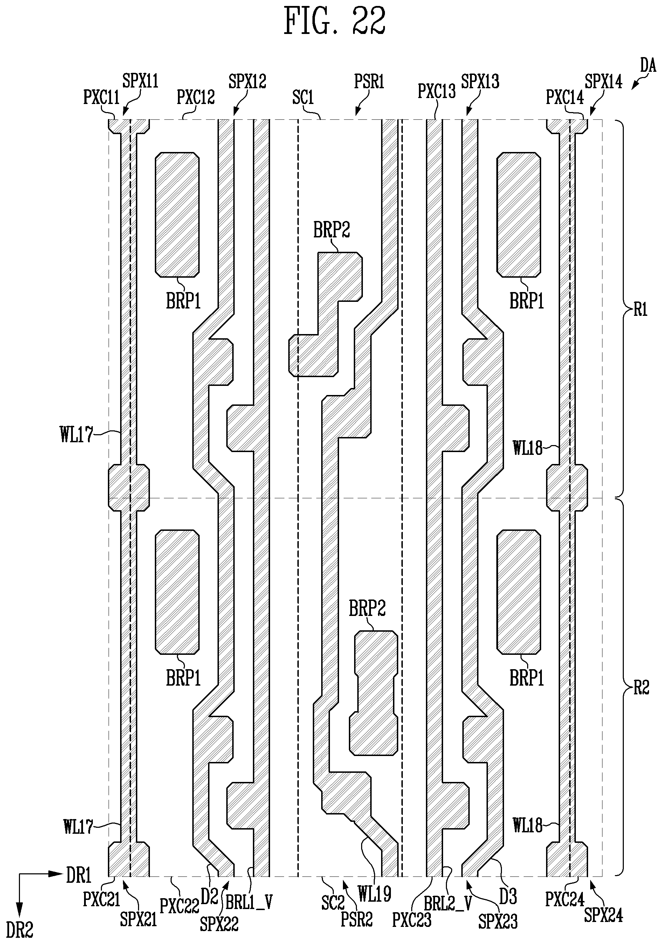

FIG. 20 is a schematic plan view illustrating sub-pixels and light-sensing pixels arranged in first and second pixel rows R1 and R2 located in one region of a display area DA of a display device in accordance with one or more embodiments, FIG. 21 is a schematic plan view illustrating only components included in a fifth conductive layer CL5 in FIG. 20, and FIG. 22 is a schematic plan view illustrating only components included in a sixth conductive layer in FIG. 20.

For convenience of explanation, FIG. 20 illustrates only components included in the fourth conductive layer, the fifth conductive layer, and the sixth conductive layer in the sub-pixels and the light-sensing pixels arranged in the first and second pixel rows R1 and R2.

In FIGS. 20 to 22, the description will focus on differences from the above-described embodiments so as to avoid redundant description.

Referring to FIGS. 20 to 22, an eleventh sub-pixel SPX11 (or a first sub-pixel), a twelfth sub-pixel SPX12 (or a second sub-pixel), a thirteenth sub-pixel SPX13 (or a third sub-pixel), and a fourteenth sub-pixel SPX14 (or a fourth sub-pixel) may be arranged in the first pixel row R1 along the first direction DR1. A twenty-first sub-pixel SPX21 (or 1a first sub-pixel), a twenty-second sub-pixel SPX22 (or a second sub-pixel), a twenty-third sub-pixel SPX23 (or a third sub-pixel), and a twenty-fourth sub-pixel SPX24 (or a fourth sub-pixel) may be arranged in the second pixel row R2 along the first direction DR1. A first light-sensing pixel PSR1 may be located between the twelfth sub-pixel SPX12 and the thirteenth sub-pixel SPX13 in the first pixel row R1. A second light-sensing pixel PSR2 may be located between the twenty-second sub-pixel SPX22 and the twenty-third sub-pixel SPX23 in the second pixel row R2. The components arranged in the first pixel row R1 (e.g., the eleventh to fourteenth sub-pixels SPX11 to SPX14 and the first light-sensing pixel PSR1) may correspond to the first to fourth sub-pixels SPX1 to SPX4 and the first light-sensing pixel PSR1 described with reference to FIGS. 10 to 19.

A first horizontal bridge line BRL1_H (or a fourteenth line WL14) extending in the first direction DR1 may be provided in the first pixel row R1. A second horizontal bridge line BRL2_H (or a fourteenth line WL14) extending in the first direction DR1 and spaced from the first horizontal bridge line BRL1_H may be provided in the second pixel row R2.

The eleventh sub-pixel SPX11 may include an eleventh pixel circuit PXC11, the twelfth sub-pixel SPX12 may include a twelfth pixel circuit PXC12, the thirteenth sub-pixel SPX13 may include a thirteenth pixel circuit PXC13, and the fourteenth sub-pixel SPX14 may include a fourteenth pixel circuit PXC14. The first light-sensing pixel PSR1 may include a first sensor circuit SC1.

The twenty-first sub-pixel SPX21 may include a twenty-first pixel circuit PXC21, the twenty-second sub-pixel SPX22 may include a twenty-second pixel circuit PXC22, the twenty-third sub-pixel SPX23 may include a twenty-third pixel circuit PXC23, and the twenty-fourth sub-pixel SPX24 may include a twenty-fourth pixel circuit PXC24. The second light-sensing pixel PSR2 may include a second sensor circuit SC2.

The twelfth sub-pixel SPX12 and the twenty-second sub-pixel SPX22 adjacent in the second direction DR2 may share a second data line D2 with each other. The thirteenth sub-pixel SPX13 and the twenty-third sub-pixel SPX23 adjacent in the second direction DR2 may share a third data line D3 with each other. The first light-sensing pixel PSR1 and the second light-sensing pixel PSR2 adjacent in the second direction DR2 may share a nineteenth line WL19 (or readout line) with each other.

The second data line D2, the nineteenth line WL19, and the third data line D3 may be part of the sixth conductive layer (see "CL6" of FIG. 16) and may be formed through the same process. In a plan view, the nineteenth line WL19 is located between the second data line D2 and the third data line D3.

In one or more embodiments, the nineteenth line WL19 may be located in different columns in the first pixel row R1 and the second pixel row R2. For example, a portion of the nineteenth line WL19 located in the first pixel row R1 may be located closer to the third data line D3 than the second data line D2. A portion of the nineteenth line WL19 located in the second pixel row R2 may be located closer to the second data line D2 than the third data line D3. That is, in a plan view, the nineteenth lines WL19 may be misaligned for each pixel row. In this case, the deviation of the coupling capacitance that occurs between the nineteenth line WL19 and the two adjacent data lines D2 and D3 for each pixel row may be reduced. For example, the coupling capacitance occurring between the nineteenth line WL19 and the second and third data lines D2 and D3 in the first pixel row R1 may be substantially identical to or similar to the coupling capacitance occurring between the nineteenth line WL19 and the second and third data lines D2 and D3 in the second pixel row R2.

In a conventional display device in which the readout lines are located on the same column without being misaligned for each pixel row, the readout line for each pixel row may be located adjacent to one of the two adjacent data lines. For example, in case that the readout line is located adjacent to the one data line in each pixel row, there may be a difference between the coupling capacitance occurring between the readout line and the one data line and the coupling capacitance occurring between the readout line and the remaining data line of the two data lines. The coupling capacitance deviation occurring for each pixel row may affect the image displayed in the display area DA, resulting in a deterioration in the reliability of the display device (see "DD" of FIG. 1).

In the embodiments described above, to reduce or prevent the coupling capacitance deviation, the nineteenth line WL19 (or readout line) may be located adjacent to (e.g. closer to) the third data line D3 among the two data lines D2 and D3, adjacent to (e.g. closer to) the nineteenth line WL 19 (or readout line) in the first pixel row R1 (or odd-numbered pixel row), and may be located adjacent to (e.g. closer to) the second data line D2 among the two data lines D2 and D3 in the second pixel row R2 (or even-numbered pixel row). Due to this, the coupling capacitance occurring between the nineteenth line WL19 and the second and third data lines D2 and D3 in the first pixel row R1 may be substantially identical to or similar to the coupling capacitance occurring between the nineteenth line WL19 and the second and third data lines D2 and D3 in the second pixel row R2. Accordingly, in the embodiments described above, defects caused by the coupling capacitance deviation of each pixel row, which have occurred in the existing display device, may be reduced, and thus, the reliability of the display device DD may be improved.

In some embodiments, the sixteenth line WL16 (e.g. in the fifth conductive layer CL5) may have different shapes in the first pixel row R1 and the second pixel row R2. For example, the sixteenth line WL16 in the first pixel row R1 may include a first sub-line WL16a extending in the first direction DR1 and a second sub-line WL16b extending from the first sub-line WL16a in the second direction DR2 and located adjacent to the nineteenth line WL19 in a plan view. The sixteenth line WL16 may include a third sub-line WL16c extending from the first sub-line WL16a in the second direction DR2 and spaced from the second sub-line WL16b. The sixteenth line WL16 in the second pixel row R2 may include a first sub-line WL16a extending in the first direction DR1 and a second sub-line WL16b extending from the first sub-line WL16a in the second direction DR2 and located adjacent to the nineteenth line WL19 in a plan view. At this time, the third sub-line WL16c does not overlap the nineteenth line WL19 and may be omitted from the second pixel row R2.

The second sub-lines WL16b of the sixteenth line WL16 that receive the reset voltage (see "VRST" of FIG. 7) may be misaligned for each pixel row. For example, the second sub-line WL16b located in the first pixel row R1 and the second sub-line WL16b located in the second pixel row R2 may not be located in the same column, but may be located in different respective columns. In a plan view, the second sub-line WL16b may be located in each pixel row so as to overlap the nineteenth line WL19 corresponding to the readout line.

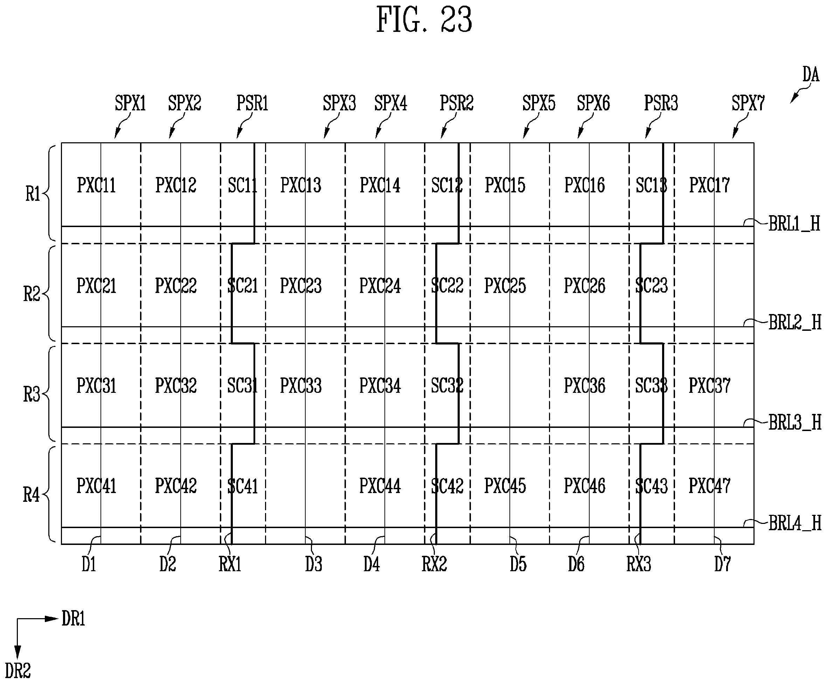

FIG. 23 is a schematic diagram illustrating a connection relationship of some lines in one region of a display area DA of a display device in accordance with one or more embodiments.

For convenience of explanation, FIG. 23 illustrates only some signal lines in sub-pixels and light-sensing pixels arranged in each of first to fourth pixel rows R1 to R4.

In FIG. 23, the description will focus on differences from the above-described embodiments so as to avoid redundant description.

Referring to FIG. 23, the display area DA may be divided into pixel rows R1 to R4. The pixel rows R1 to R4 may extend in the first direction DR1, and may be arranged in the second direction DR2. Each of the pixel rows R1 to R4 may include first to seventh sub-pixels SPX1 to SPX7. Each of the first to seventh sub-pixels SPX1 to SPX7 may include a pixel circuit. Each of the pixel rows R1 to R4 may include first to third light-sensing pixels PSR1 to PSR3. Each of the first to third light-sensing pixels PSR1 to PSR3 may include a sensor circuit.

In one or more embodiments, the sub-pixels SPX1 to SPX7 may be arranged in the first direction DR1 in the order of the first sub-pixel SPX1, the second sub-pixel SPX2, the third sub-pixel SPX3, the fourth sub-pixel SPX4, the fifth sub-pixel SPX5, the sixth sub-pixel SPX6, and the seventh sub-pixel SPX7 in each of the first to fourth pixel rows R1 to R4. In each of the first to fourth pixel rows R1 to R4, the first light-sensing pixel PSR1 may be located between the second sub-pixel SPX2 and the third sub-pixel SPX3, the second light-sensing pixel PSR2 may be located between the fourth sub-pixel SPX4 and the fifth sub-pixel SPX5, and the third light-sensing pixel PSR3 may be located between the sixth sub-pixel SPX6 and the seventh sub-pixel SPX7.

In the first pixel row R1, pixel circuits PXC11 to PXC17 corresponding to the sub-pixels SPX1 to SPX7 of the first pixel row R1 may be arranged in the first direction DR1. In the first pixel row R1, pixel circuits PXC11 to PXC13 corresponding to the light-sensing pixels PSR1 to PSR3 of the first pixel row R1 may be arranged in the first direction DR1.

In the second pixel row R2, pixel circuits PXC21 to PXC27 corresponding to the sub-pixels SPX1 to SPX7 of the second pixel row R2 may be arranged in the first direction DR1. In the second pixel row R2, sensor circuits SC21 to SC23 corresponding to the light-sensing pixels PSR1 to PSR3 of the second pixel row R2 may be arranged in the first direction DR1.

In the third pixel row R3, pixel circuits PXC31 to PXC37 corresponding to the sub-pixels SPX1 to SPX7 of the third pixel row R3 may be arranged in the first direction DR1. In the third pixel row R2, sensor circuits SC31 to SC33 corresponding to the light-sensing pixels PSR1 to PSR3 of the third pixel row R3 may be arranged in the first direction DR1.

In the fourth pixel row R4, pixel circuits PXC41 to PXC47 corresponding to the sub-pixels SPX1 to SPX7 of the fourth pixel row R4 may be arranged in the first direction DR1. In the fourth pixel row R4, sensor circuits SC41 to SC43 corresponding to the light-sensing pixels PSR1 to PSR3 of the fourth pixel row R4 may be arranged in the first direction DR1.

A first horizontal bridge line BRL1_H may be located in the first pixel row R1, a second horizontal bridge line BRL2_H may be located in the second pixel row R2, a third horizontal bridge line BRL3_H may be located in the third pixel row R3, and a fourth horizontal bridge line BRL4_H may be located in the fourth pixel row R4.

A first data line D1 may be located in the first sub-pixels SPX1 of the first to fourth pixel rows R1 to R4. A second data line D2 may be located in the second sub-pixels SPX2 of the first to fourth pixel rows R1 to R4. A third data line D3 may be located in the third sub-pixels SPX3 of the first to fourth pixel rows R1 to R4. A fourth data line D4 may be located in the fourth sub-pixels SPX4 of the first to fourth pixel rows R1 to R4. A fifth data line D5 may be located in the fifth sub-pixels SPX5 of the first to fourth pixel rows R1 to R4. A sixth data line D6 may be located in the sixth sub-pixels SPX6 of the first to fourth pixel rows R1 to R4. A seventh data line D7 may be located in the seventh sub-pixels SPX7 of the first to fourth pixel rows R1 to R4.

A first readout line RX1 may be located in the first light-sensing pixels PSR1 of the first to fourth pixel rows R1 to R4. A second readout line RX2 may be located in the second light-sensing pixels PSR2 of the first to fourth pixel rows R1 to R4. A third readout line RX3 may be located in the third light-sensing pixels PSR3 of the first to fourth pixel rows R1 to R4.

The first readout line RX1 may be located between the second data line D2 and the third data line D3, the second readout line RX2 may be located between the fourth data line D4 and the fifth data line D5, and the third readout line RX3 may be located between the sixth data line D6 and the seventh data line D7.

Each of the first to third readout lines RX1 to RX3 may be located adjacent to (closer to) the respective data line located on the right side thereof than the respective data line located on the left side thereof among two adjacent data lines in the odd-numbered pixel rows, for example, the first and third pixel rows R1 and R3. For example, in each of the first and third pixel rows R1 and R3, the first readout line RX1 may be located closer to the third data line D3 than the second data line D2, the second readout line RX2 may be located closer to the fifth data line D5 than the fourth data line D4, and the third readout line RX3 may be located closer to the seventh data line D7 than the sixth data line D6.

Each of the first to third readout lines RX1 to RX3 may be located adjacent to (closer to) the respective data line located on the left side thereof than the respective data line located on the right side thereof among two adjacent data lines in the even-numbered pixel rows, for example, the second and fourth pixel rows R2 and R4. For example, in each of the second and fourth pixel rows R2 and R4, the first readout line RX1 may be located closer to the second data line D2 than the third data line D3, the second readout line RX2 may be located closer to the fourth data line D4 than the fifth data line D5, and the third readout line RX3 may be located closer to the sixth data line D6 than the seventh data line D7.

As the first to third readout lines RX1 to RX3 located in the odd-numbered pixel rows and the first to third readout lines RX1 to RX3 located in the even-numbered pixel row are arranged in different columns, the coupling capacitance occurring between each readout line in the odd-numbered pixel row and the two data lines adjacent thereto may be substantially identical to or similar to the coupling capacitance occurring between each readout line in the even-numbered pixel row and the two data lines adjacent to each other.

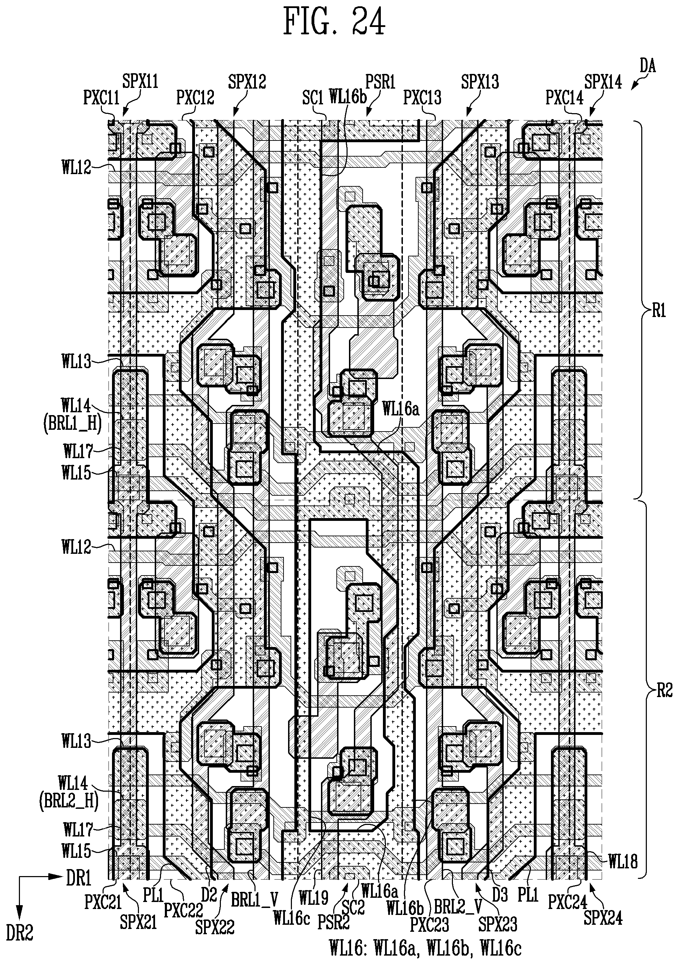

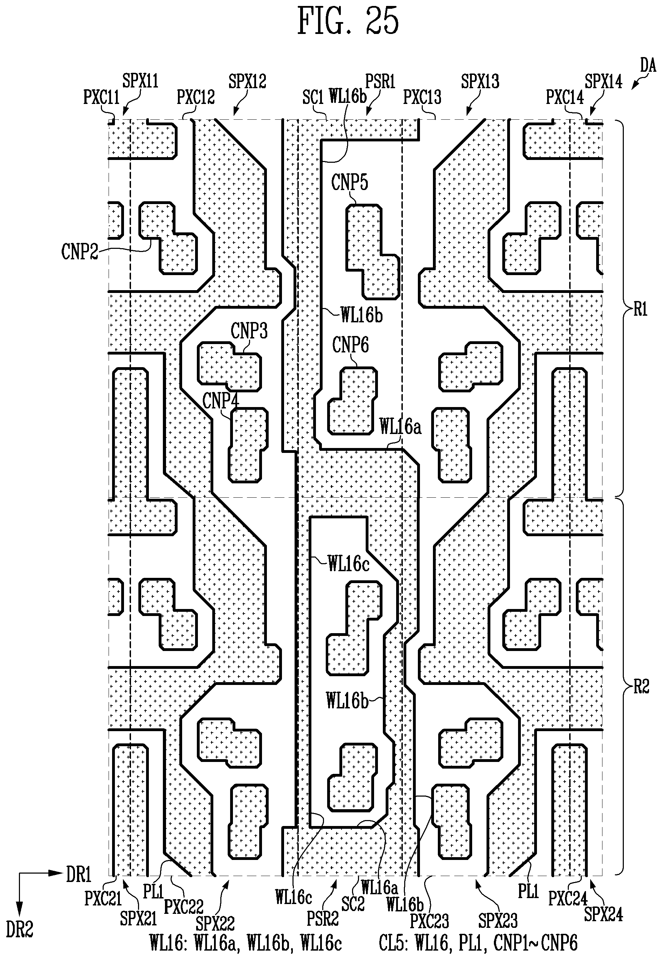

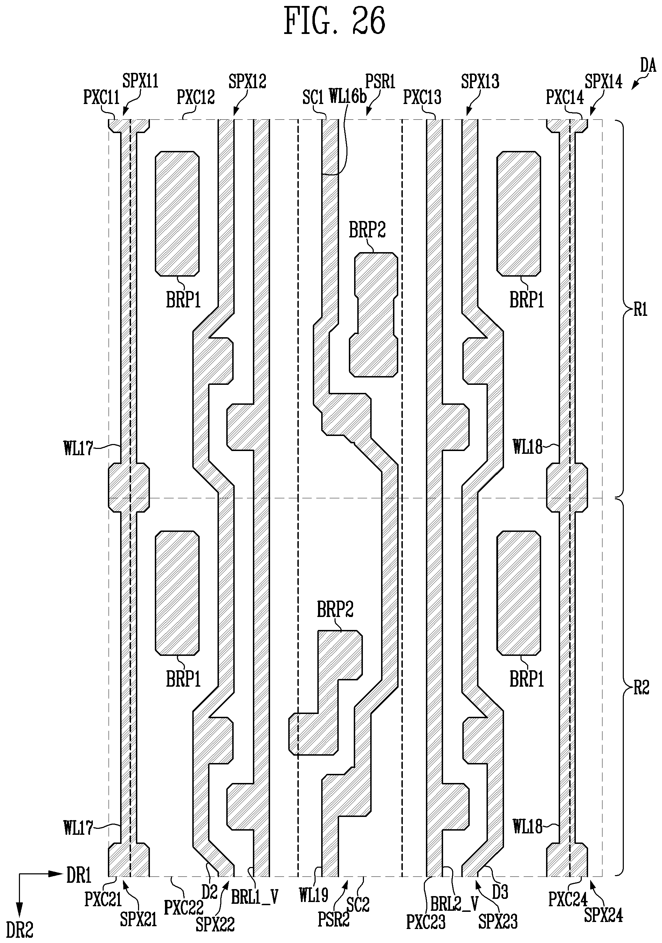

FIG. 24 is a schematic plan view illustrating sub-pixels and light-sensing pixels arranged in first and second pixel rows R1 and R2 located in one region of a display area DA of a display device in accordance with one or more embodiments, FIG. 25 is a schematic plan view illustrating only components included in a fifth conductive layer CL5 in FIG. 24, and FIG. 26 is a schematic plan view illustrating only components included in a sixth conductive layer in FIG. 24.

For convenience of explanation, FIG. 24 illustrates only components included in the fourth conductive layer, the fifth conductive layer, and the sixth conductive layer in the sub-pixels and the light-sensing pixels arranged in the first and second pixel rows R1 and R2.

In FIGS. 24 to 26, the description will focus on differences from the above-described embodiments so as to avoid redundant description.

Referring to FIGS. 24 to 26, nineteenth lines WL19 corresponding to readout lines may be located in different columns in the first pixel row R1 and the second pixel row R2. For example, the nineteenth line WL19 located in the first pixel row R1 may be located closer to the second data line D2 than the third data line D3. The nineteenth line WL19 located in the second pixel row R2 may be located closer to the third data line D3 than the second data line D2. That is, in a plan view, the nineteenth lines WL19 may be misaligned for each pixel row. In this case, the deviation of the coupling capacitance that occurs between the nineteenth line WL19 and the two adjacent data lines D2 and D3 for each pixel row may be reduced. For example, the coupling capacitance occurring between the nineteenth line WL19 and the second and third data lines D2 and D3 in the first pixel row R1 may be substantially identical to or similar to the coupling capacitance occurring between the nineteenth line WL19 and the second and third data lines D2 and D3 in the second pixel row R2.

In some embodiments, the sixteenth line WL16 (e.g. of the fifth conductive layer CL5) may have different shapes in the first pixel row R1 and the second pixel row R2. For example, the sixteenth line WL16 in the first pixel row R1 may include a first sub-line WL16a extending in the first direction DR1, and a second sub-line WL16b extending from the first sub-line WL16a in the second direction DR2 and located adjacent to the nineteenth line WL19 in a plan view. The sixteenth line WL16 in the second pixel row R2 may include a first sub-line WL16a extending in the first direction DR1, a second sub-line WL16b extending from the first sub-line WL16a in the second direction DR2 and located adjacent to the nineteenth line WL19 in a plan view, and a third sub-line WL16c extending from the first sub-line WL16a in the second direction DR2 and spaced from the second sub-line WL16b. At this time, the third sub-line WL16c does not overlap the nineteenth line WL19 and may be omitted from the first pixel row R1.

The second sub-lines WL16b of the sixteenth line WL16 that receive the reset voltage (see "VRST" of FIG. 7) may be misaligned for each pixel row. For example, the second sub-line WL16b located in the first pixel row R1 and the second sub-line WL16b located in the second pixel row R2 may not be located in the same column, but may be located in different columns. In a plan view, the second sub-line WL16b may be located in each pixel row so as to overlap the nineteenth line WL19 corresponding to the readout line.

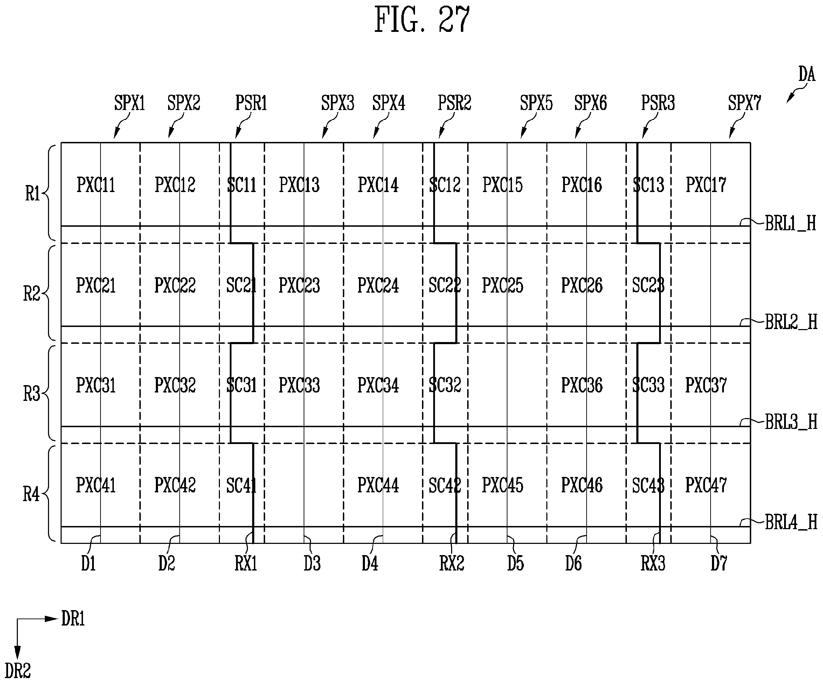

FIG. 27 is a schematic diagram illustrating a connection relationship of some lines in one region of a display area DA of a display device in accordance with one or more embodiments.

For convenience of explanation, FIG. 27 illustrates only some signal lines in sub-pixels and light-sensing pixels arranged in each of first to fourth pixel rows R1 to R4.

In FIG. 27, the description will focus on differences from the above-described embodiments so as to avoid redundant description.

Referring to FIG. 27, the first readout line RX1 may be located between the second data line D2 and the third data line D3, the second readout line RX2 may be located between the fourth data line D4 and the fifth data line D5, and the third readout line RX3 may be located between the sixth data line D6 and the seventh data line D7.

Each of the first to third readout lines RX1 to RX3 may be located adjacent to (closer to) the respective data line located on the left side thereof than the respective data line located on the right side thereof among two adjacent data lines in the odd-numbered pixel rows, for example, the first and third pixel rows R1 and R3. For example, in each of the first and third pixel rows R1 and R3, the first readout line RX1 may be located closer to the second data line D2 than the third data line D3, the second readout line RX2 may be located closer to the fourth data line D4 than the fifth data line D5, and the third readout line RX3 may be located closer to the sixth data line D6 than the seventh data line D7.

Each of the first to third readout lines RX1 to RX3 may be located adjacent to (closer to) the data line located on the right side than the data line located on the left side among two adjacent data lines in the even-numbered pixel rows, for example, the second and fourth pixel rows R2 and R4. For example, in each of the second and fourth pixel rows R2 and R4, the first readout line RX1 may be located closer to the third data line D3 than the second data line D2, the second readout line RX2 may be located closer to the fifth data line D5 than the fourth data line D4, and the third readout line RX3 may be located closer to the seventh data line D7 than the sixth data line D6.

As the first to third readout lines RX1 to RX3 located in the odd-numbered pixel rows and the first to third readout lines RX1 to RX3 located in the even-numbered pixel row are arranged in different columns, the coupling capacitance occurring between each readout line in the odd-numbered pixel row and the two data lines adjacent thereto may be substantially identical to or similar to the coupling capacitance occurring between each readout line in the even-numbered pixel row and the two data lines adjacent to each other.

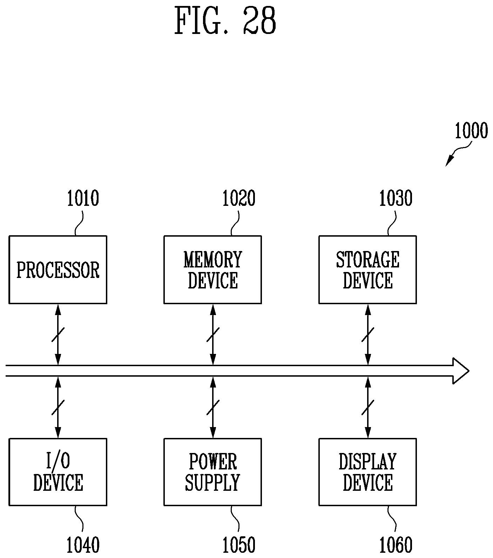

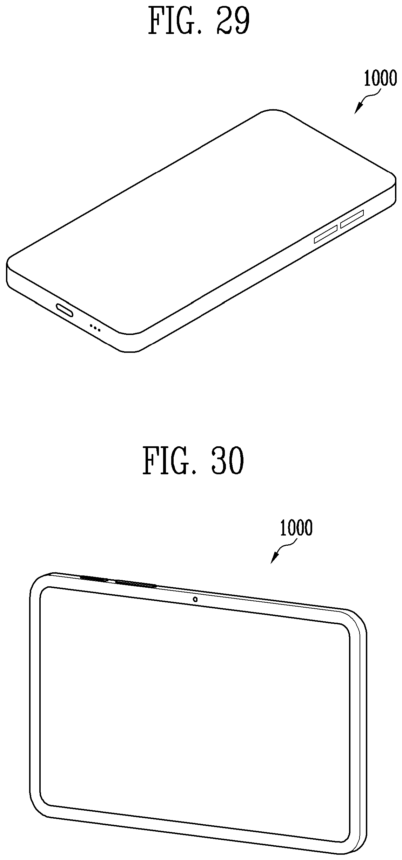

FIG. 28 is a schematic block diagram illustrating an electronic device 1000 in accordance with one or more embodiments, FIG. 29 is a schematic diagram illustrating an example in which the electronic device 1000 of FIG. 28 is implemented as a smartphone, and FIG. 30 is a schematic diagram illustrating an example in which the electronic device 1000 of FIG. 28 is implemented as a tablet PC.

Referring to FIGS. 28 to 30, the electronic device 1000 may include a processor 1010, a memory device 1020, a storage device 1030, an input/output (I/O) device 1040, a power supply 1050, and a display device 1060. At this time, the display device 1060 may be the display device DD of FIGS. 1 and 2. The electronic device 1000 may further include a plurality of ports that may communicate with a video card, a sound card, a memory card, a universal serial bus (USB) device, etc., or may communicate with other systems. In one or more embodiments, as illustrated in FIG. 29, the electronic device 1000 may be implemented as a smartphone. In one or more other embodiments, as illustrated in FIG. 30, the electronic device 1000 may be implemented as a tablet PC. However, this is only an example, and the electronic device 1000 is not limited to the above-described example. For example, the electronic device 1000 may be implemented as a mobile phone, a video phone, a smart pad, a smart watch, a vehicle navigation, a computer monitor, a laptop, a head mounted display, etc.

The processor 1010 may perform corresponding computations or tasks. In accordance with one or more embodiments, the processor 1010 may be a microprocessor, a central processing unit, an application processor, etc. The processor 1010 may be connected to other components through an address bus, a control bus, and a data bus. In accordance with one or more embodiments, the processor 1010 may also be connected to an expansion bus, such as a peripheral component interconnect (PCI) bus.

The memory device 1020 may store data necessary for the operation of the electronic device 1000. For example, the memory device 1020 may include non-volatile memory devices, such as an erasable programmable read-only memory (EPROM) device, an electrically erasable programmable read-only memory (EEPROM) device, a flash memory device, a phase change random access memory (PRAM) device, a resistance random access memory (RRAM) device, a nano floating gate memory (NFGM) device, a polymer random access memory (PoRAM) device, a magnetic random access memory (MRAM), or a ferroelectric random access memory (FRAM) devices, and/or volatile memory devices, such as a dynamic random access memory (DRAM) device, a static random access memory (SRAM) devices, or a mobile DRAM device.

The storage device 1030 may include solid state drive (SSD), hard disk drive (HDD), compact disc read-only memory (CD-ROM), etc.

The I/O device 1040 may include an input means, such as a keyboard, a keypad, a touch pad, a touch screen, or a mouse, and an output means, such as a speaker or a printer. In accordance with one or more embodiments, the display device 1060 may be included in the I/O device 1040.

The power supply 1050 may supply power necessary for the operation of the electronic device 1000. For example, the power supply 1050 may be a power management integrated circuit (PMIC).

The display device 1060 may display an image corresponding to visual information of the electronic device 1000. At this time, the display device 1060 may be an organic light-emitting display device or a quantum dot light-emitting display device, but the present disclosure is not limited thereto. The display device 1060 may be connected to other components via the buses or other communication links.

In accordance with one or more embodiments, a readout line may be located between first and second data lines adjacent to each other. The readout line may be located adjacent to one of the first or second data lines (for example, the second data line) in a first pixel row (or an odd-numbered pixel row), and may be located adjacent to the other of the first and second data lines (for example, the first data line) in a second pixel row (or an even-numbered pixel row).

In accordance with one or more embodiments, a coupling capacitance occurring between the readout line in the odd-numbered pixel row and the first and second data lines may be similar or identical to a coupling capacitance occurring between the readout line in the even-numbered pixel row and the first and second data lines. Accordingly, coupling capacitance deviation that may occur between adjacent data lines and the readout line in a display area (or a display panel) may be reduced or prevented.

In accordance with one or more embodiments, a reset line may be located between a readout line and a horizontal bridge line to reduce coupling capacitances that may occur between the readout line and the horizontal bridge line, thereby further improving the reliability of a display device and an electronic device including the same.

Aspects in accordance with the embodiments are not limited to those described above, and further various aspects are included in the present specification.

Although the present disclosure has been described above with reference to preferred embodiments, those skilled in the art or those of ordinary skill in the art will understand that various modifications and changes may be made to the present disclosure without departing from the technical scope of the present disclosure described in the appended claims.

Therefore, the technical scope of the present disclosure should not be limited to those described in the detailed description of the specification, but should be determined by the appended claims, with functional equivalents thereof to be included therein.

## Claims

1. A display device comprising:
a substrate (SUB);
first sub-pixels (SPX1), second sub-pixels (SPX2), and third sub-pixels (SPX3) respectively arranged in a first pixel row (R1) and a second pixel row (R2) extending in a first direction (DR1);
light-sensing pixels (PSR1) between respective ones of the second sub-pixels (SPX2) and the third sub-pixels (SPX3) in the first pixel row (R1) and the second pixel row (R2), and comprising a sensor circuit (SC);
a first data line (D2) electrically connected to the second sub-pixels;
a second data line (D3) electrically connected to the third sub-pixels; and
a readout line (WL19) electrically connected to the light-sensing pixels, between the first data line (D2) and the second data line (D3) in plan view, adjacent to one of the first data line (D2) or the second data line (D3) in the first pixel row (R1), and adjacent to a remaining one of the first data line (D2) or the second data line (D3) in the second pixel row (R2).

2. The display device of claim 1, wherein the readout line (WL19) is closer to the second data line (D3) than the first data line (D2) in the first pixel row (R1), and is closer to the first data line (D2) than the second data line (D3) in the second pixel row (R2), or
wherein the readout line (WL19) is closer to the first data line (D2) than the second data line (D3) in the first pixel row (R1), and is closer to the second data line (D3) than the first data line (D2) in the second pixel row (R2).

3. The display device of any one of the preceding claims 1 to 2, wherein the first data line (D2), the readout line (WL19), and the second data line (D3) are at a same layer.

4. The display device of any one of the preceding claims 1 to 3, further comprising:
a reset line (RSTL) electrically connected to the light-sensing pixels, and configured to receive a reset voltage (VRST);
a horizontal bridge line (WL14, BRL_H) extending in the first direction in the first pixel row (R1) and the second pixel row (R2); and/or
a first vertical bridge line (BRL1_V) at the second sub-pixels in the first pixel row (R1) and the second pixel row (R2); and/or
a second vertical bridge line (BRL2_V) at the second sub-pixels in the first pixel row (R1) and the second pixel row (R2).

5. The display device of claim 4, wherein the reset line (RSTL) comprises:
a first line (WL15) at a same layer as the horizontal bridge line (WL14, BRL_H), and extending in the first direction (DR1); and
a second line (WL16) between the first line (WL15) and the readout line (WL19), electrically connected to the first line (WL15), and comprising a first sub-line (WL16a) extending in the first direction (DR1), and a second sub-line (WL16b) extending in a second direction (DR2) crossing the first direction (DR1), and overlapping the readout line (WL19).

6. The display device of claim 5, wherein the first sub-line (WL16a) is in an overlap area (OVA) where the horizontal bridge line (WL14, BRL_H) and the readout line (WL19) overlap.

7. The display device of claim 6, wherein the first sub-line (WL16a) is configured to shield a coupling capacitance between the horizontal bridge line (WL14, BRL_H) and the readout line (WL19) in the overlap area (OVA).

8. The display device of any one of the preceding claims 5 to 7, wherein the second line (WL16) further comprises a third sub-line (WL16c) in the first pixel row (R1), extending from the first sub-line (WL16a) in the second direction (DR2), spaced from the second sub-line (WL16b), and not overlapping the readout line (WL19) in plan view.

9. The display device of any of the preceding claims 5 to 8, wherein the second sub-line (WL16b) is closer to the second data line (D3) than the first data line (D2) in the first pixel row (R1), and is closer to the first data line (D2) than the second data line (D3) in the second pixel row (R1).

10. The display device of any one of the preceding claims 5 to 7, wherein the second line (WL16) further comprises a third sub-line (WL16c) in the second pixel row (R2), extending from the first sub-line (WL16a) in the second direction (D2), spaced from the second sub-line (WL16b), and not overlapping the readout line (WL19), and/or wherein the sub-line (WL) is closer to the first data line (D2) than the second data line (D3) in the first pixel row (R1), and is closer to the second data line (D3) than the first data line (D2) in the second pixel row (R2).

11. The display device of any one of the preceding claims 1 to 10, wherein the first sub-pixels (SPX1), the second sub-pixels (SPX2), and the third sub-pixels (SPX3) comprise a light-emitting element configured to emit light, and
wherein the light-sensing pixels (PSR1) comprise a light-receiving element configured to output a sensing signal corresponding to the light.

12. The display device of any one of the preceding claims 5 to 11, further comprising:
first (INS1), second (INS2), third (INS3), fourth (INS4), fifth (INS5), sixth (INS6), seventh (INS7), eighth (INS8), and ninth insulating layers (INS9) sequentially arranged above the substrate (SUB);
a first conductive layer (CL1) between the second insulating layer (INS2) and the third insulating layer (INS3);
a second conductive layer (CL2) between the third insulating layer (INS3) and the fourth insulating layer (INS4);
a third conductive layer (CL3) between the fifth insulating layer (INS5) and the sixth insulating layer (INS6);
a fourth conductive layer (CL4) between the sixth insulating layer (INS6) and the seventh insulating layer (INS7), and comprising the horizontal bridge line (WL14, BRL_H);
a fifth conductive layer (CL5) between the seventh insulating layer (INS7) and the eighth insulating layer (INS8), and comprising the first sub-line (WL16a) and the second sub-line (WL16b); and
a sixth conductive layer (CL6) between the eighth insulating layer (INS8) and the ninth insulating layer (INS9), and comprising the first vertical bridge line (BRL1_V) and the second vertical bridge line (BRL2_V), the first and second data lines (D2, D3), and the readout line (WL19).

13. The display device of one of the preceding claims 1 to 12, the first data line (D2) extending in the second direction (DR2) crossing the first direction (DR1);
the second data line (D3) extending in the second direction (DR2);
the readout line (WL19) extending in the second direction (DR2); and
a reset line (RSTL) electrically connected to the light-sensing pixels, configured to receive a reset voltage (VRST), and comprising:
a first line (WL15) extending in the first direction (DR1); and
a second line (WL16) above the first line (WL15) with an insulating layer (INS7) therebetween, electrically connected to the first line (WL15), and comprising:
a first sub-line (WL16a) extending in the first direction (DR1) and overlapping the first line (WL15); and
a second sub-line (WL16b) overlapping the readout line (WL19) and extending from the first sub-line (16a) along the second direction (DR2).

14. The display device of any one of the preceding claims 1 to 13, wherein the readout line (WL19) and/or the second sub-line (WL16b) is in different respective columns in the first pixel row (R1) and in the second pixel row (R2).

15. An electronic device (1000) comprising:
a processor (1010) configured to provide input image data; and
a display device (1060) configured to display an image based on the input image data, and comprising according to any one of the preceding claims 1 to 14.
